(19) Europäisches Patentamt
European Patent Office
Office européen des brevets

(11) **EP 2 936 686 B1**

(12) **EUROPÄISCHE PATENTSCHRIFT**

(45) Veröffentlichungstag und Bekanntmachung des Hinweises auf die Patenterteilung:
**18.05.2022  Patentblatt 2022/20**

(21) Anmeldenummer: **13802000.3**

(22) Anmeldetag: **25.11.2013**

(51) Internationale Patentklassifikation (IPC):
**H03M 1/06** *(2006.01)*      **H03M 1/66** *(2006.01)*

(52) Gemeinsame Patentklassifikation (CPC):
**H03M 1/0612; H03M 1/66**

(86) Internationale Anmeldenummer:
**PCT/EP2013/074632**

(87) Internationale Veröffentlichungsnummer:
**WO 2014/095247 (26.06.2014 Gazette 2014/26)**

(54) **UMFORMERSCHALTUNG MIT EINER STROMSCHNITTSTELLE SOWIE MESSGERÄT MIT EINER SOLCHEN UMFORMERSCHALTUNG**

TRANSFORMER CIRCUIT WITH A CURRENT INTERFACE AND MEASURING INSTRUMENT WITH SUCH A TRANSFORMER CIRCUIT

CIRCUIT CONVERTISSEUR AVEC INTERFACE DE COURANT ET APPAREIL DE MESURE ÉQUIPÉ D'UN TEL CIRCUIT CONVERTISSEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.12.2012  DE 102012112930**
**28.01.2013  DE 102013100799**

(43) Veröffentlichungstag der Anmeldung:
**28.10.2015  Patentblatt 2015/44**

(60) Teilanmeldung:
**22167366.8**

(73) Patentinhaber: **Endress+Hauser Flowtec AG**
**4153 Reinach (BL) (CH)**

(72) Erfinder:
• **SIMON, Antoine**
**F-68300 St. Louis (FR)**
• **KLEIN, Francois**
**F-68220 Hagenthul de Haut (FR)**

(74) Vertreter: **Andres, Angelika Maria**
**Endress+Hauser Group Services (Deutschland) AG+Co. KG**
**Colmarer Straße 6**
**79576 Weil am Rhein (DE)**

(56) Entgegenhaltungen:
**WO-A1-95/08123     WO-A1-2008/000631**

• **"Complete Closed-Loop Precision Analog Microcontroller Thermocouple Measurement System with 4 mA to 20 mA Output", Analog Devices Circuit Note CN-0300, Oktober 2012 (2012-10), Seiten 1-6, XP55104896, Gefunden im Internet: URL:http://datasheet.elcodis.com/pdf2/124/42/1244250/eval-cn0300-eb1z.pdf [gefunden am 2014-02-28]**
• **Abdulkadir Cakir ET AL: "Microcontroller circuit calibrates current loops", Test & Measurement World, Februar 2012 (2012-02), Seiten 26-29, XP55104898, Gefunden im Internet: URL:http://m.eet.com/media/1166791/26258-tmw_1202_f2_loop.pdf [gefunden am 2014-02-28]**
• **MIJANOVIC Z ET AL: "R/2R<+> digital-analog converter (DAC)", INSTRUMENTATION AND MEASUREMENT TECHNOLOGY CONFERENCE, 1996. IMTC-96. CONFERENCE PROCEEEDINGS. QUALITY MEASUREMENTS: THE INDISPENSABLE BRIDG E BETWEEN THEORY AND REALITY., IEEE BRUSSELS, BELGIUM 4-6 JUNE 1996, NEW YORK, NY, USA,IEEE, US, Bd. 2, 4. Juni 1996 (1996-06-04), Seiten 1034-1039, XP010164030, DOI: 10.1109/IMTC.1996.507322 ISBN: 978-0-7803-3312-3**

• CATTEAU B ET AL: "A Digital Calibration Technique for the Correction of Glitches in High-Speed DAC's", CIRCUITS AND SYSTEMS, 2007. ISCAS 2007. IEEE INTERNATIONAL SYMPOSIUM O N, IEEE, PI, Mai 2007 (2007-05), Seiten 1477-1480, XP031181555, DOI: 10.1109/ISCAS.2007.378582 ISBN: 978-1-4244-0920-4

**EP 2 936 686 B1**

**Beschreibung**

Die Erfindung betrifft eine, insb. zur Verwendung in einem digitalem Meßumformer mit analogem Ausgangssignal geeignete, Umformerschaltung zum Wandeln eines einen zeitlichen Verlauf einer zeitlich veränderlichen physikalischen und/oder chemischen Meßgröße repräsentierenden digitalen Meßsignals in ein von nämlichem digitalen Meßsignal abhängiges analoges Meßwertsignal mit einem Signalstrom von dem eine Stromstärke einen Meßwert für die Meßgröße repräsentiert. Desweiteren besteht die Erfindung in einem mittels einer solchen Umformerschaltung gebildeten Meßgerät.

In der industriellen Meß- und Automatisierungstechnik werden, insb. auch im Zusammenhang mit der Automation chemischer oder verfahrenstechnischer Prozesse und/oder der automatisierten Steuerung von industriellen Anlagen, unmittelbar an der jeweiligen Anlage installierte, gelegentlich auch als Feldgeräte oder auch als Feldmeßgeräte bezeichnete, Meßgeräte, wie z.B. Coriolis-Massendurchfluß-Meßgeräte, Dichte-Meßgeräte, magnetisch-induktive Durchflußmeßgeräte, Wirbel-Durchflußmeßgeräte, Ultraschall-Durchflußmeßgeräte, thermische Massendurchfluß-Meßgeräte, Druck-Meßgeräte, Füllstand-Meßgeräte, Temperatur-Meßgeräte, pH-Wert-Meßgeräte etc., eingesetzt, die jeweils der Ermittlung von eine jeweils innerhalb eines vorgegebenen Meßbereichs zeitlich veränderliche physikalische und/oder chemische Meßgröße repräsentierenden Meßwerten sowie der Erzeugung von jeweils wenigstes einem nämliche Meßwerte extern des jeweiligen Meßgeräts übertragenden - digitalen oder analogen - Meßwertsignal dienen. Bei der mittels des jeweiligen Meßgeräts jeweils zu erfassenden Meßgröße kann es sich, je nach Anwendung, beispielsweise um einen Massendurchfluß, eine Dichte, eine Viskosität, einen Füll- oder einen Grenzstand, einen Druck, ein pH-Wert, eine elektrische Leitfähigkeit oder eine Temperatur oder dergleichen, eines flüssigen, pulver-, dampf- oder gasförmigen Mediums handeln, das in einem entsprechenden Behälter, wie z.B. einer Rohrleitung oder einem Tank, geführt bzw. vorgehalten wird. Solche, dem Fachmann an und für sich bekannte Meßgeräte sind u.a. in der EP-A 1 591 977, der GB-A 22 29 897, der US-A 2001/0016802, der US-A 2010/0026322, der US-A 2011/0062942, der US-A 56 72 975, der US-A 60 14 100, der US-A 61 40 940, der US-B 64 52 493, der US-B 64 72 884, der US-B 66 84 340, der US-B 71 62 651, der US-B 72 96 482, der US-B 76 30 844, der US-B 77 78 784, der US-B 77 92 646, WO-A 00/26739, der WO-A 00/48157, der WO-A 01/71291, der WO-A 03/106931, der WO-A 2008/091548, der WO-A 2009/002341, der WO-A 2011/005938, der WO-A 2012/009003, der WO-A 2012/159683, der WO-A 88/02476, der WO-A 88/02853, der WO-A 94/20940, der WO-A 95/08123 , der WO-A 95/08758 oder auch der eigenen, nicht vorveröffentlichten internationalen Anmeldung PCT/EP2012/057791 gezeigt bzw. werden von der Anmelderin selbst, beispielsweise unter der Bezeichnung t-trend ATT12, Promag 53H, Prowirl 73F, Promass E 200, Promass F 200, Promass 83X, oder Promass 84F, gewerblich angeboten.

Zum Erfassen der jeweiligen Prozeßgrößen weisen Meßgeräte der vorgenannten Art jeweils einen entsprechenden physikalisch-elektrischen oder chemisch-elektrischen Meßaufnehmer auf. Dieser ist zumeist in eine Wandung des das Medium jeweils führenden Behälters oder der in den Verlauf einer das Medium jeweils führenden Leitung, beispielsweise eine Rohrleitung, eingesetzt und dient dazu, wenigstens ein mit der zu erfassenden Meßgröße entsprechend korrespondierendes, nämlich deren zeitlichen Verlauf repräsentierenden zunächst analoges elektrisches Meßsignals zu generieren, das wiederum mittels einer an den Meßwandler elektrisch angeschlossenen Meßgerät-Elektronik weiterverarbeitet wird, derart, daß entsprechende Meßwerte für die Meßgrößen ermittelt werden. Die Meßgerät-Elektronik des jeweiligen Meßgeräts ist zumeist in einem vergleichsweise robusten, etwa schlag-, druck-, explosions- und/oder wetterfesten, Elektronik-Gehäuse untergebracht. Dieses kann z.B. vom Meßaufnehmer entfernt angeordnet und mit diesem nur über eine flexible Leitung verbunden sein; es kann aber auch direkt am Meßaufnehmer bzw. an einem den Meßaufnehmer separat einhausenden Meßaufnehmer-Gehäuse angeordnet sein. Die Meßgerät-Elektronik von Meßgeräten der in Rede stehenden ist im Betrieb zudem über entsprechende Anschlußklemmen und damit verbundene elektrische Anschlußleitungen an ein vom jeweiligen Meßgerät zumeist räumlich entfernt angeordnetes, zumeist auch räumlich verteiltes, übergeordnetes elektronisches Datenverarbeitungssystem elektrisch angeschlossen, an das die vom jeweiligen Meßgerät erzeugten Meßwerte mittels des Meßwertesignals in einem vom Datenverarbeitungssystem verarbeitbaren Format weitergegeben werden. Sehr verbreitet ist in der Meßtechnik, nicht zuletzt auch für den Fall, Meßwertsignale über größere, beispielsweise in der Größenordnung von 10 m bis einige hundert Meter liegende, Distanzen hinweg zu übertragen sind, die Verwendung von analogen Stromsignalen, nämlich von analogen Meßwertsignalen, bei denen eine momentane Stromstärke eines eingeprägten gleichwohl innerhalb einer vorgegebenen Meßspanne, nämlich innerhalb eines zur Übertragung von Meßwerten reservierten Strombereichs, veränderlichen Signalstrom jeweils genau einen Meßwert für die Meßgröße repräsentiert. In der industriellen Meßtechnik werden zur Übertragung von Meßwerten oftmals sogenannte 4 - 20 mA Stromschleifen, mithin als Meßwertesignale solche Signalströme verwendet, die innerhalb einer zwischen einer auf etwa 3,8 mA festgesetzten - gelegentlich auch als stromführender Nullpunkt oder Life-Zero-Wert bezeichneten - unteren Grenzstromstärke sowie einer auf etwa 20,5 mA festgesetzten oberen Grenzstromstärke liegenden Meßspanne veränderlich sind. Unterhalb bzw. oberhalb nämlicher, u.a. auch in der Norm DIN IEC 60381-1 definierten, Meßspanne liegende Stromstärkebereich sind bei 4 - 20 mA Stromschleifen zumeist für die Signalisierung vorab definierter, von einem dem normalen Meßbetrieb des jeweiligen Meßgeräts entsprechenden Normalbetriebsmodus abweichenden Sonderbetriebszuständen, beispielsweise Alarmzuständen infolge einer außerhalb eines für das Meßgerät spezifizierten Meßbereich liegende Meßgröße oder infolge eines Ausfalls des jeweiligen Meßaufnehmers, entsprechenden Sonderbetriebsmoden des Meßgeräts reserviert, etwa auch um den in der NAMUR-Empfehlung NE43:18.01.1994 formulierten Anforderungen an vereinheitlichte Signalpegel für die Ausfallinformation digitaler Meßumformer mit analogem Ausgangssignal zu genügen.

Zum Erzeugen des Meßwertsignals wird bei modernen Meßgeräten der in Rede stehenden Art mittels einer, beispielsweise unmittelbar am Meßaufnehmer und/oder innerhalb des erwähnten Elektronik-Gehäuses angeordneten, Analog-zu-Digital-Wandlers zunächst aus dem analogen elektrischen Meßsignal des Meßwandlers ein dieses repräsentierendes digitales Meßsignal gewonnen. Zum weiteren Verarbeiten des digital Meßsignals, nämlich zum Erzeugen von die jeweilige Meßgröße repräsentierenden digitalen Meßwerten sowie zum Umwandeln nämlicher Meßwerte in zumindest ein extern des Meßgerät-Elektronik übertrag- und auswertbares Meßwertesignal der vorbeschriebenen Art, weist die Meßgerät-Elektronik ferner eine das digitale Meßsignal empfangende Umformerschaltung auf. Wie u.a. auch in der eingangs erwähnten US-A 2001/0016802, US-A 2010/0026322, US-A 2011/0062942, US-B 76 30 844, US-B 77 92 646, US-B 77 78 784, US-B 64 52 493, US-A 60 14 100, WO-A 95/08123 oder WO-A 2012/009003 jeweils gezeigt, sind nämliche Umformerschaltungen bei modernen Meßgeräten der in Rede stehenden Art zumeist mittels eines, gelegentlich auch mehr als einen Prozessor und/oder eine digitalen Signalprozessors (DSP) aufweisenden, digitalen Mikroprozessors gebildet, dem über einen Meßsignaleingang das digitale Meßsignal zugeführt ist. Nämlicher Mikroprozessor ist u.a auch dafür eingerichtet, basierend auf dem digitalen Meßsignal am Meßsignaleingang eine Meßwertefolge, nämlich eine einen zeitlichen Verlauf der Meßgröße repräsentierende Sequenz von für verschiedene Zeitpunkte gewonnenen, die Meßgröße jeweils momentan repräsentierenden digitalen Meßwerten zu generieren.

Für den erwähnten Fall, daß das als Meßwertsignal ein analoges Stromsignal ausgegeben werden soll, weist nämliche Umformerschaltung ferner eine vom Mikroprozessor gesteuerte Stromschnittstelle mit wenigstens einem Stromausgang und mit einem Steuereingang auf, die dafür eingerichtet ist, den Signalstrom durch den Stromausgang fließen zu lassen und währenddessen sowohl dessen Stromstärke auf einen vom Mikroprozessor an einem entsprechenden Steuerausgang vorgegebenen, an nämlichem Steuereingang momentan angelegten Steuerwert entsprechenden stationären Stromstärkepegel einzuregeln, derart, daß jeder der stationären Stromstärkepegel gemäß einer der Stromschnittstelle immanenten, nämlich durch die Betriebsparameter der die Stromschnittstelle bildenden elektronischen Komponenten bestimmten Kennlinienfunktion von jeweils einem zugehörigen Steuerwert abhängig ist. Die Stromschnittstelle kann hierbei als eine passive, nämlich einen von einer extern des Meßgeräts angeordneten Versorgungsschaltung getriebenen Strom im Sinne einer Lastmodulation einstellende Schnittstelle, oder als aktive, nämlich einen von einer internen Versorgungsschaltung des Meßgeräts getriebenen Strom variierende Schnittstelle ausgebildet sein. Im Mikroprozessor ist ferner eine entsprechende, von wenigstens zwei vorgegebenen Koeffizienten bestimmten Rechenvorschrift hinterlegt, die festlegt wie jeder der Steuerwerte der Steuerwertefolge in Abhängigkeit von den digitalen Meßwerte der Meßwertefolge zu ermitteln ist. Nämliche Rechenvorschrift ist zumeist eine von genau zwei Koeffizienten bestimmte lineare Funktion bzw. Polynomfunktion vom Polynomgrad Eins. Insgesamt weisen somit Umformerschaltungen der in Rede stehenden Art eine durch nämliche Rechenvorschrift und die der Stromschnittstelle innewohnende Kennlinienfunktion bestimmte Umformerkennlinie auf, gemäß der die jeweilige Umformerschaltung jeden der Meßwerte in einen entsprechenden Stromstärkepegel wandelt bzw. gemäß der eine innerhalb des jeweils vorgegebenen Meßbereichs liegende Meßgröße auf den Signalstrom abgebildet wird.

Üblicherweise sind solche Stromschnittstellen mittels eines linearen Stromreglers und einem diesem vorgeschalteten Digital-zu-Analog-Wandler zur Konvertierung des digitalen in einen entsprechend analogen Steuerwert für den einzustellen Signalstrom gebildet. Den momentanen Stromstärkepegel erfaßt der lineare Stromreglers dabei mittels einer über einem vom Signalstrom durchflossenen Meßwiderstand abfallenden analogen Meßspannung. Wie in der eingangs erwähnten WO-A 95/08123 ferner gezeigt, können nämliche Stromschnittstellen zudem einen mittels eines nämliche Meßspannung digitalisierenden Analog-zu-Digitalwandlers gebildeten Stromsignalausgang aufweisen, an dem eine Stromwertefolge, nämliche eine einen zeitlichen Verlauf der tatsächlich eingestellten Stromstärke des Signalstroms repräsentierende Sequenz von für verschiedene Zeitpunkte gewonnenen, die jeweilige Stromstärke jeweils repräsentierenden digitalen Stromwerten ausgegeben wird. Über einen mit nämlichem Stromsignalausgang entsprechend verbundenen Stromsignaleingang des Mikroprozessors können die digitalen Stromwerte vom Mikroprozessor eingelesen und weiterverarbeitet werden, beispielsweise nämlich zur Ermittlung einer Abhängigkeit einer Klemmenspannung, die zwischen zwei jeweils mit einer extern des Meßgeräts verlaufenden, im Betrieb den Signalstrom führenden Anschlußleitung verbundene Anschlußklemmen meßbar ist, von der mittels der Stromschnittstelle für den Signalstrom tatsächlich eingestellten Stromstärke verwendet werden.

Meßgeräte der in Rede stehenden Art sind auch nach deren Inbetriebnahme, insb. im Sinne einer Nachkalibrierung, gelegentlich daraufhin zu überprüfen - sei es auf Veranlassung des das Meßgerät betreibenden Anwenders und/oder auf Anforderung einer die mittels des Meßgerät gebildete Meßstelle beaufsichtigenden Behörde -, ob die geforderte bzw. in der Spezifikation ausgewiesene Meßgenauigkeit, nämlich jene Genauigkeit, mit der die Meßgröße schlußendlich auf das Meßwersignal abgebildet wird, nach wie vor verläßlich erreicht ist. Ein besonderes Augenmerk kommt bei solchen Überprüfung von Meßgeräten der in Rede stehenden Art u.a. auch deren jeweiliger Stromschnittstelle zu. Dies nicht zuletzt auch deshalb, weil regelmäßig davon auszugehen ist, daß die der Stromschnittstelle aktuell innewohnende Kennlinienfunktion, gemäß der die Stromstärke des Signalstroms in Abhängigkeit vom zugehörigen Steuerwert momentan tatsächlich einstellt wird, alterungsbedingt von einer der jeweiligen Stromschnittstelle ursprünglich, nämlich zu einem früheren Zeitpunkt, beispielsweise während einer Kalibrierung beim Hersteller oder während einer Inbetriebnahme des Meßgeräts, innewohnenden Kennlinienfunktion abweichen kann. Die Überprüfung der Stromschnittstelle erfolgt herkömmlicherweise dadurch, daß ein Strommeßgerät, beispielsweise ein digitale Amperemeter, in den mittels der Stromschnittstelle gebildeten Stromkreis eingeschleift wird, derart, daß auch nämliches Strommeßgerät auch den Signalstrom führen kann, und hernach der Mikroprozessor, ausgelöst durch einen entsprechenden Startbefehl, ein entsprechendes Testprogramm ausführt, in dem ein Ensemble vorab definierter Prüf-Steuerwerte nacheinander an die Stromschnittstelle übergeben und eine dementsprechende Abfolge von Stromstärkepegeln erzeugt wird. Als Prüf-Steuerwerte werden zumeist auch jene Steuerwerten verwendet, die der mit Bereichsuntergrenze und/oder der Bereichsobergrenze des Meßbereichs korrespondierende Grenzstromstärke des Meßspanne entsprechen, beispielsweise also Steuerwerten für 4 mA bzw. von 20 mA entsprechen. Der in Abhängigkeit vom jeweiligen Prüf-Steuerwert tatsächlich eingestellte stationäre Stromstärkepegel wird mittels des Strommeßgerät jeweils genau gemessen und entsprechend angezeigt. Zum Zweck der Dokumentation der Überprüfung können die Prüf-Steuerwerte zusammen mit dem jeweiligen Meßwert für dementsprechend tatsächlich eingestellten Stromstärkepegel auch mittels eines, beispielsweise an das Strommeßgerät direkt angeschlossenen oder darin implementierten, digitalen Aufzeichnungsgerät gespeichert werden. Gleichermaßen können auch die jeweils vom Mikroprozessor eingestellten Prüf-Steuerwerte am Meßgerät zur Anzeige gebracht und/oder an das - zumindest für diesen Fall über eine entsprechende Serviceschnittstelle der Meßgerät-Elektronik mit dem Mikroprozessor kommunizierende - digitale Aufzeichnungsgerät zwecks Speicherung übermittelt werden.

Die vom Strommeßgerät ermittelten Meßwerte für die einzelnen Stromstärkepegel werden im Anschluß an die Strommessung mit dem jeweils zugehörigen Prüf-Steuerwert verglichen, derart, daß jeweils eine Abweichung des tatsächlich eingestellten stationären Stromstärkepegels vom jeweiligen Prüf-Steuerwert ermittelt wird. Falls sämtliche der Abweichungen innerhalb eines vorgegebenen Toleranzbandes liegen, mithin keine signifikante Abweichung der aktuellen von der ursprünglichen Kennlinienfunktion der Stromschnittstelle festzustellen ist, kann die Überprüfung der jeweiligen Stromschnittstelle als bestanden eingestuft werden, anderenfalls kann eine entsprechende Neujustierung der Umformerschaltung erforderlich sein. Solch eine Justierung kann bei konventionellen Umformerschaltungen z.B. dadurch erfolgen, daß die Meßwerte für die verschiedenen Stromstärkepegel in den Mikroprozessor eingelesen werden, beispielsweise durch manuelle Eingabe über eine daran angeschlossene Tastatur oder durch direktes Auslesen aus dem erwähnten Aufzeichnungsgerät, und der Mikroprozessor basierend auf nämlichen Meßwerte, den jeweils zugehörigen Prüf-Steuerwerten, sowie den im Mikroprozessor hinterlegten Koeffizienten der Rechenvorschrift zur Ermittlung der Steuerwerte ein neuer Satz Ersatz-Koeffizienten für die Rechenvorschrift berechnet und hernach die Rechenvorschrift modifiziert wird, indem hernach die Ersatz-Koeffizienten anstelle der ursprünglichen Koeffizienten für die Rechenvorschrift verwendet werden. Die Modifizierung nämlicher Rechenvorschrift kann bei herkömmlichen Meßgeräten beispielsweise auch erfolgen, indem die Meßwerte für die Stromstärkepegel, die jeweils zugehörigen Prüf-Steuerwerten zusammen mit den im Mikroprozessor hinterlegten Koeffizienten zunächst von einem extern des Meßgeräts bereitgehaltenen, ggf. auch via Serviceschnittstelle oder per Funkschnittstelle mit der Umformerschaltung kommunizierenden, portablen Rechner, beispielsweise einem Laptop oder einem Tablet-Computer, eingelesen und basierend darauf die entsprechenden Ersatz-Koeffizienten errechnet werden, die hernach wiederum an den Mikroprozessor der Umformerschaltung übergeben werden.

Eine weitere gattungsgemäße Umformerschaltung ist aus der Offenbarung "Complete Closed-Loop Precision Analog Microcontroller Thermocouple Measurement System with 4 mA to 20 mA Output" - Analog Devices Circuit Note CN-0300 von Oktober 2012, Seiten 1-6, XP055104896, bekannt.

Ein Nachteil konventioneller Meßgerät-Elektroniken der vorgenannten Art bzw. der darin implementierten Umformerschaltungen ist darin zu sehen, daß zur Überprüfung von deren Stromschnittstelle der normale Meßbetrieb des Meßgerät unterbrochen, mithin der von der Meßstelle aus überwachte Anlagenteil für die Dauer der Überprüfung außer Betrieb genommen werden muß. Darüberhinaus erfordert eine solche Überprüfung ein zumeist sehr teures bzw. gleichermaßen wiederkehrend zu kalibrierendes Strommeßgerät, mithin ein spezielles Prüfmittel. Ein weiterer Nachteil von herkömmlichen Meßgerät-Elektronik der in Rede stehenden Art bzw. deren jeweiliger Umformerschaltung ist in diesem Zusammenhang auch darin zu sehen, daß zum einen die Überprüfung der Stromschnittstelle erhebliche manuelle Eingriffe an dem jeweiligen, mittels des zu überprüfenden Meßgeräts sowie dem daran angeschlossenen Datenverarbeitungssystem gebildeten Meßsystem, hier nämlich das vorübergehende Einschleifen des für die Überprüfung unabdingbaren Strommeßgeräts, bedingt, und zum anderen auch eine allfällige Modifikation der Rechenvorschrift für die Steuerwerte weitere spezielle Prüfmittel inform eines entsprechend kommunikationsfähigen Aufzeichnungsgeräts und/oder eines entsprechend programmierten Rechners, mithin einen nicht unerheblichen technischen Mehraufwand erfordert.

Dem Rechnung tragend besteht eine Aufgabe der Erfindung darin, Meßgerät-Elektroniken der in Rede stehenden Art, mithin damit gebildete Meßgeräte, dahingehend zu verbessern, daß nämliches Überprüfen der Stromschnittstelle auch allein mit bordeigenen, nämlich von der Meßgerät-Elektronik bereitgestellten Prüfmitteln, mithin auch ohne weitere manuelle Eingriff an installierten, nämlich via Anschlußleitungen bereits an ein übergeordnetes Datenverarbeitungssystem angeschlossen Meßgeräten bzw. auch ohne spezielle externe Prüfmittel erfolgen kann, und zwar möglichst auch ohne langwährende Unterbrechungen des normalen Meßbetriebs.

Zur Lösung der Aufgabe besteht die Erfindung in einer Umformerschaltung, die dazu dient, ein einen zeitlichen Verlauf einer - beispielsweise innerhalb eines vorgegebenen Meßbereichs - zeitlich veränderlichen physikalischen und/oder chemischen Meßgröße repräsentierendes digitalen Meßsignals in ein von nämlichem digitalen Meßsignal abhängiges analoges Meßwertsignal mit einem Signalstrom von dem eine Stromstärke einen Meßwert für die Meßgröße repräsentiert, zu wandeln. Die Umformerschaltung umfaßt dafür eine Stromschnittstelle mit einem Steuereingang, mit einem Stromsignalausgang, und mit einem Stromausgang sowie einen Mikroprozessor mit einem Meßsignaleingang für das digitale Meßsignal, mit einem mit dem Stromsignalausgang der Stromschnittstelle verbundenen Stromsignaleingang und mit einem mit dem Steuereingang der Stromschnittstelle verbundenen Steuerausgang. Bei der erfindungsgemäßen Umformerschaltung ist die Stromschnittstelle ferner dafür eingerichtet, den Signalstrom durch den Stromausgang fließen zu lassen und währenddessen sowohl die Stromstärke des Signalstroms auf einen einem am Steuereingang momentan angelegten Steuerwert entsprechenden stationären Stromstärkepegel einzuregeln, derart, daß jeder der stationären Stromstärkepegel gemäß einer der Stromschnittstelle immanenten - beispielsweise linearen - Kennlinienfunktion von jeweils einem zugehörigen Steuerwert abhängig ist, als auch am Stromsignalausgang eine Stromwertefolge, nämlich eine einen zeitlichen Verlauf der Stromstärke des Signalstroms repräsentierende Sequenz von für verschiedene Zeitpunkte gewonnenen, die Stromstärke momentan repräsentierenden digitalen Stromwerten, auszugeben. Desweiteren ist bei der erfindungsgemäßen Umformerschaltung der Mikroprozessor dafür eingerichtet, basierend auf dem digitalen Meßsignal am Meßsignaleingang eine Meßwertefolge, nämlich eine einen zeitlichen Verlauf der Meßgröße repräsentierende Sequenz von für verschiedene Zeitpunkte gewonnenen, die Meßgröße jeweils momentan repräsentierenden digitalen Meßwerten zu generieren, und basierend auf der Meßwertefolge eine Steuerwertefolge, nämliche eine Sequenz von digitalen Steuerwerten für die Stromschnittstelle, zu generieren und am Steuerausgang auszugeben, sowie basierend auf der Steuerwertefolge und der Stromwertefolge - beispielsweise nämlich basierend auf zumindest vorübergehend gespeicherten Steuerwerten sowie zumindest vorübergehend gespeicherten digitalen Stromwerten - die Stromschnittstelle zu überwachen und/oder zu überprüfen.

Darüberhinaus besteht die Erfindung in einem Meßgerät, umfassend: einen Meßaufnehmer zum Erfassen einer - beispielsweise innerhalb eines vorgegebenen Meßbereichs - zeitlich veränderlichen physikalischen und/oder chemischen Meßgröße und zum Generieren wenigstens eines einen zeitlichen Verlauf nämlicher Meßgröße repräsentierenden analogen Meßsignals sowie einen mit dem Meßaufnehmer elektrisch gekoppelte - beispielsweise in einem Elektronik-Gehäuse untergebrachte - Meßgerät-Elektronik, die dafür eingerichtet ist, das analoge Meßsignal in ein dieses, mithin einen zeitlichen Verlauf nämlicher Meßgröße repräsentierendes digitales Meßsignal zu wandeln, und die solche eine Umformerschaltung auifweist.

Bei der erfindungsgemäßen Umformerschaltung ist der Mikroprozessor dafür eingerichtet, basierend auf der Steuerwertefolge und der Stromwertefolge - beispielsweise basierend auf zumindest vorübergehend gespeicherten Steuerwerten sowie zumindest vorübergehend gespeicherten digitalen Stromwerten - die Stromschnittstelle zu überprüfen, nämlich eine Abweichung zwischen einem Steuerwert und wenigstens einem zugehörigen digitalen Stromwert zu ermitteln; und/oder festzustellen, inwieweit nämlicher Stromwert vom Steuerwert abweicht; und/oder eine aktuelle Kennlinienfunktion, gemäß der die Stromschnittstelle die stationären Stromstärkepegel in Abhängigkeit von den digitalen Steuerwerten einstellt, zu ermitteln; und/oder festzustellen, ob bzw. inwieweit eine aktuelle Kennlinienfunktion, gemäß der die Stromschnittstelle die stationären Stromstärkepegel in Abhängigkeit von den digitalen Steuerwerten einstellt, von einer zuvor für die Stromschnittstelle ermittelten Kennlinienfunktion abweicht.

Außerdem ist die erfindungsgemäße Umformerschaltung dafür eingerichtet, zeitweise - beispielsweise vorwiegend - in einem Normalbetriebsmodus betrieben zu werden, in dem die Meßgröße lediglich innerhalb eines dafür vorgegebenen Meßbereichs mit einer durch einen vorgegebenen kleinsten Meßwert für Meßgröße bestimmten Bereichsuntergrenze und einer durch einen vorgegebenen größten Meßwert für Meßgröße bestimmten Bereichsobergrenze zeitlich ändert, und in dem vom lediglich solche Steuerwerte am Steuerausgang ausgegeben werden, die die Stromschnittstelle veranlassen, die Stromstärke des Signalstroms so zu regeln, daß die stationären Stromstärkepegel jeweils innerhalb einer dafür vorgegebenen, nämlich mit dem für die Meßgröße vorgegebenen Meßbereich korrespondierenden, mithin eine mit dessen Bereichsuntergrenze korrespondierende erste Grenzstromstärke sowie eine mit dessen Bereichsobergrenze korrespondierende, von der ersten Grenzstromstärke verschiedene zweite Grenzstromstärke aufweisenden Meßspanne liegen. Die erste Grenzstromstärke kann hierbei z.B. 4 mA oder weniger, insb. mehr als 3,6 mA, bzw. die zweite Grenzstromstärke kann hierbei z.B. 20 mA oder mehr, insb. weniger als 21 mA, betragen.

Darüber hinaus ist die erfindungsgemäße Umformerschaltung ferner eingerichtet - beispielsweise veranlaßt durch eine Störung der Umformerschaltung bzw. des digitalen Meßsignals und/oder veranlaßt durch eine außerhalb des Meßbereichs liegenden [0060] Meßgröße und/oder veranlaßt durch eine unzulässig hohen Abweichung wenigstens eines der stationären Stromstärkepegel von dem dafür vorgegebenen Steuerwert - zeitweise in einem Sonderbetriebsmodus betrieben zu werden, in dem vom Mikroprozessor am Steuerausgang, insb. ausschließlich, solche Steuerwerte ausgegeben werden, die die Stromschnittstelle veranlassen, die Stromstärke des Signalstroms so zu regeln, daß die stationären Stromstärkepegel außerhalb der vorgegebenen Meßspanne liegen.

Nach einer weiteren Ausgestaltung der erfindungsgemäßen Umformerschaltung ist vorgesehen, daß die Stromschnittstelle einen Freigabeeingang und der Mikroprozessor einen mit nämlichem Freigabeeingang der Stromschnittstelle verbundenen Freigabeausgang aufweisen, und daß die Stromschnittstelle zudem dafür eingerichtet ist, die Stromwertefolge am Stromsignalausgang auszugeben, nachdem ein den Stromsignalausgang aktivierender Steuerbefehl am Freigabeeingang angelegt ist bzw. der Mikroprozessor dafür eingerichtet ist, einen Steuerbefehl zum Aktivieren des Stromsignalausgangs zu generieren und am Freigabeausgang auszugeben. Diese Ausgestaltung der Erfindung weiterbildend ist ferner vorgesehen, daß die Stromschnittstelle, zeitweise - beispielsweise bei Ausbleiben des den Stromsignalausgang aktivierenden Steuerbefehls bzw. nachdem ein vom Mikroprozessor generierter, den Stromsignalausgang deaktivierender Steuerbefehl am Freigabeeingang angelegt ist - keine Stromwertefolge am Stromsignalausgang ausgibt. Dies beispielsweise auch derart, daß eine Aktivierungszeit, nämlich eine über einen vorgegeben Betriebszeitraum kumulierte Gesamtzeit, während der die Stromschnittstelle die Stromwertefolge am Stromsignalausgang ausgibt, kürzer ist als eine Deaktivierungszeit, nämlich eine über einen vorgegeben Betriebszeitraum kumulierte Gesamtzeit, während der die Stromschnittstelle die Stromwertefolge am Stromsignalausgang nicht ausgibt.

Nach einer weiteren Ausgestaltung der Erfindung ist der Mikroprozessor dafür eingerichtet, basierend auf der Steuerwertefolge und der Stromwertefolge - beispielsweise basierend auf gespeicherten Steuerwerten sowie gespeicherten digitalen Stromwerten - einen Umformerfehler zu ermitteln.

Nach einer weiteren Ausgestaltung der Erfindung ist die Umformerschaltung dafür eingerichtet ist, basierend auf der Steuerwertefolge und der Stromwertefolge zumindest gelegentlich zu überprüfen, ob ein stationärer Stromstärkepegel mit dem dafür vorgegebenen Steuerwert übereinstimmt bzw. inwieweit ein stationärer Stromstärkepegel von dem dafür vorgegebenen Steuerwert abweicht.

Nach einer weiteren Ausgestaltung der Erfindung ist der Mikroprozessor dafür eingerichtet, die Steuerwerte der Steuerwertefolge basierend auf einer von wenigstens zwei vorgegebenen, momentan gültigen Koeffizienten bestimmten Rechenvorschrift als Funktionswert einer, insb. linearen, Funktion wenigstens eines der digitalen Meßwerte der Meßwertefolge zu ermitteln. Diese Ausgestaltung der Erfindung weiterbildend ist der Mikroprozessor ferner dafür eingerichtet, basierend auf der Steuerwertefolge und der Stromwertefolge - beispielsweise basierend auf gespeicherten Steuerwerten sowie gespeicherten digitalen Stromwerten - nämliche Rechenvorschrift auf eine aktuelle Kennlinienfunktion, gemäß der die Stromschnittstelle die stationären Stromstärkepegel in Abhängigkeit von den digitalen Steuerwerten einstellt, abzugleichen - beispielsweise derart, daß eine Abweichung der aktuellen Kennlinienfunktion von einer zuvor für die Stromschnittstelle ermittelten Kennlinienfunktion kompensiert wird. Diese Ausgestaltung der Erfindung weiterbildend ist der Mikroprozessor dafür eingerichtet, gelegentlich - beispielsweise nachdem eine Abweichung eines stationären Stromstärkepegels von dem dafür vorgegebenen Steuerwert bzw. eine Abweichung einer aktuellen Kennlinienfunktion, gemäß der die Stromschnittstelle die stationären Stromstärkepegel in Abhängigkeit von den digitalen Steuerwerten einstellt, von einer zuvor für die Stromschnittstelle ermittelten Kennlinienfunktion festgestellt ist - wenigstens einen Ersatz-Koeffizienten für wenigstens einen der momentan gültigen gleichwohl zu ersetzenden Koeffizienten zu ermitteln. Dafür ist vorgesehen, daß die - beispielsweise zuvor in einem störungsfreien Normalbetriebsmodus betriebenen - Umformerschaltung zeitweise in einem Sonderbetriebsmodus versetzt wird - automatisch und/oder gesteuert durch den Mikroprozessor bzw. einen an diesen von extern übermittelten Steuerbefehl - , in dem vom Mikroprozessor am Steuerausgang - beispielsweise ausschließlich - solche Steuerwerte ausgegeben werden, die die Stromschnittstelle veranlassen, die Stromstärke des Signalstroms so zu regeln, daß die stationären Stromstärkepegel außerhalb der vorgegebenen Meßspanne liegen, und indem der Mikroprozessor den Ersatz-Koeffizienten ermittelt - beispielsweise derart, daß zum Ermitteln des wenigstens eines Ersatz-Koeffizienten wenigsten zwei voneinander abweichende Steuerwerte vom Mikroprozessor ausgegeben werden, von denen wenigstens einer die Stromschnittstelle veranlaßt, die Stromstärke des Signalstroms so zu regeln, daß der zugehörige stationäre Stromstärkepegel unterhalb einer für eine Meßspanne vorgegebene kleinsten Grenzstromstärken liegt, und/oder von denen wenigsten einer die Stromschnittstelle veranlaßt, die Stromstärke des Signalstroms so zu regeln, daß der zugehörige stationäre Stromstärkepegel oberhalb einer für eine Meßspanne vorgebene größten Grenzstromstärken liegt.

Nach einer weiteren Ausgestaltung der Erfindung ist der Mikroprozessor dafür eingerichtet, die Steuerwerte der Steuerwertefolge als eine lineare Funktion eines der digitalen Meßwerte der Meßwertefolge, nämlich basierend auf einer von genau zwei vorgegebenen, momentan gültigen Koeffizienten bestimmten Polynomfunktion vom Polynomgrad, $N-1 = 1$, zu ermitteln.

Nach einer weiteren Ausgestaltung der Erfindung ist die Umformerschaltung dafür eingerichtet, in einem Inbetriebnahmemodus betrieben zu werden, in dem der Mikroprozessor zunächst gestartet wird und hernach, nämlich während des Inbetriebnahmemodus, die Stromschnittstelle zu überprüfen. Diese Ausgestaltung der Erfindung weiterbildend ist ferner vorgesehen, daß der Mikroprozessor die Stromschnittstelle während des Inbetriebnahmemodus überprüft, indem am Steuerausgang ein Life-Zero-Steuerwert, nämlich ein Steuerwert ausgegeben wird, der die Stromschnittstelle veranlaßt, die Stromstärke des Signalstroms so zu regeln, daß der zugehörige stationäre Stromstärkepegel einem Life-Zero-Wert, nämlich einer einen stromführenden Nullpunkt der Umformerschaltung signalisierenden Stromstärke, entspricht. Desweiteren ist vorgesehen, daß der Mikroprozessor die Stromschnittstelle während des Inbetriebnahmemodus überprüft, indem am Steuerausgang - beispielsweise zu einem späteren Zeitpunkt - ein vom Life-Zero-Steuerwert abweichender Steuerwert ausgegeben wird, der die Stromschnittstelle veranlaßt, die Stromstärke, $I_X$, des Signalstroms so zu regeln, daß der zugehörige stationäre Stromstärkepegel einem oberhalb des Life-Zero-Wert liegenden - beispielsweise einem mehr als 20,5 mA und weniger als 23 mA betragenden Alarmstromwert - Stromwert entspricht. Basierend auf dem Life-Zero-Steuerwert, wenigstens einem nämlichem Life-Zero-Steuerwert entsprechenden digitalen Stromwert, dem vom Life-Zero-Steuerwert abweichenden Steuerwert sowie wenigstens einem nämlichem Steuerwert entsprechenden digitalen Stromwert kann der Mikroprozessor die Stromschnittstelle während des Inbetriebnahmemodus überprüfen, indem eine aktuelle Kennlinienfunktion, gemäß der die Stromschnittstelle die stationären Stromstärkepegel in Abhängigkeit von den digitalen Steuerwerten einstellt, ermittelt und mit einer dafür vorgegebenen Kennlinienfunktion verglichen wird und/oder sowohl eine Abweichung zwischen dem Life-Zero-Steuerwert und dem zugehörigen digitalen Stromwert als auch eine Abweichung zwischen dem anderen vom Life-Zero-Steuerwert abweichenden Steuerwert und dem zugehörigen digitalen Stromwert ermittelt werden und hernach festgestellt wird, ob jede der beiden ermittelten Abweichungen innerhalb bzw. außerhalb eines dafür vorgegebenen, zulässige Abweichungen repräsentierenden Toleranzbereichs liegt.

Nach einer ersten Weiterbildung der erfindungsgemäßen Umformerschaltung ist ferner vorgesehen, daß diese weiters einen persistenten Datenspeicher aufweist. Ferner kann der Mikroprozessor zudem dafür eingerichtet sein, beipielsweise wenigstens einem zugehörigen digitalen Stromwert und/oder eine Abweichung zwischen einem Steuerwert und einem zugehörigen digitalen Stromwert nicht-flüchtig im Datenspeicher zu speichern, ggf. zusammen mit einem Zeitwert, der mit einem Zeitpunkt des Speicherns korrespondiert.

Nach einer zweiten Weiterbildung der erfindungsgemäßen Umformerschaltung ist ferner vorgesehen, daß diese weiters einen flüchtigen Datenspeicher zum Speichern von digitalen Meßwerten und/oder digitalen Steuerwerten umfaßt. Ferner kann der Mikroprozessor zudem dafür eingerichtet sein, digitale Steuerwerte sowie digitale Stromwerte vorübergehend im Datenspeicher zu speichern.

Nach einer ersten Weiterbildung des erfindungsgemäßen Meßgeräts umfaßt die Meßgerät-Elektronik weiters ein vom Mikroprozessor angesteuertes Anzeigeelement zum Anzeigen von mittels des Mikroprozessors generierten Meßwerten und zum Anzeigen eines mittels eines Stromwerts und eines Steuerwerts gebildeten Wertepaares und/oder einer Abweichung eines Stromwerts von einem Steuerwert und/oder zum Anzeigen eines Umformerfehlers.

Nach einer zweiten Weiterbildung des erfindungsgemäßen Meßgeräts umfaßt die Meßgerät-Elektronik eine erste Anschlußklemme, die dafür eingerichtet ist, mit einer ersten extern der Umformerschaltung verlegten Anschlußleitung elektrisch verbunden zu werden, und eine zweite Anschlußklemme, die dafür eingerichtet ist, mit einer zweiten extern der Umformerschaltung verlegten Anschlußleitung elektrisch verbunden zu werden. Diese Ausgestaltung der Erfindung weiterbildend ist ferner vorgesehen, daß der Stromausgang der Stromschnittstelle zwei Anschlußelektroden aufweist, von welchen Anschlußelektroden eine erste Anschlußelektrode mit der ersten Anschlußklemme und eine zweite Anschlußelektrode mit der zweiten Anschlußklemme elektrisch verbunden sind.

Nach einer dritten Weiterbildung des erfindungsgemäßen Meßgeräts umfaßt die Meßgerät-Elektronik eine erste Anschlußklemme, die dafür eingerichtet ist, mit einer ersten extern der Umformerschaltung verlegten Anschlußleitung elektrisch verbunden zu werden, eine zweite Anschlußklemme, die dafür eingerichtet ist, mit einer zweiten extern der Umformerschaltung verlegten Anschlußleitung elektrisch verbunden zu werden, eine dritte Anschlußklemme, die dafür eingerichtet ist, mit einer dritten extern des Umformerschaltungs verlegten Anschlußleitung elektrisch verbunden zu werden, sowie eine vierte Anschlußklemme, die dafür eingerichtet ist, mit einer vierten extern des Umformerschaltungs verlegten Anschlußleitung elektrisch verbunden zu werden.

Nach einer vierten Weiterbildung des erfindungsgemäßen Meßgeräts umfaßt die Meßgerät-Elektronik eine Energieversorgungsschaltung mit einem Eingang und mit wenigstens einem Ausgang, die dafür eingerichtet ist, an nämlichem Ausgang eine Nutzspannung zum Betreiben des Mikroprozessors und/oder zum Betreiben der Stromschnittstelle bereitzustellen. Diese Ausgestaltung der Erfindung weiterbildend ist die Energieversorgungsschaltung ferner dafür eingerichtet, zumindest einem Anteil des Signalstroms zu führen und dazu zu verwenden, die Nutzspannung zum Betreiben des Mikroprozessors und/oder zum Betreiben der Stromschnittstelle bereitzustellen.

Nach einer fünften Weiterbildung des erfindungsgemäßen Meßgeräts umfaßt die Meßgerät-Elektronik eine Energieversorgungsschaltung mit einem Eingang und mit wenigstens einem Ausgang, die dafür eingerichtet ist, an nämlichem Ausgang eine Nutzspannung zum Betreiben des Mikroprozessors und/oder zum Betreiben der Stromschnittstelle bereitzustellen, und umfaßt die Meßgerät-Elektronik eine erste Anschlußklemme, die dafür eingerichtet ist, mit einer ersten extern der Umformerschaltung verlegten Anschlußleitung elektrisch verbunden zu werden, eine zweite Anschlußklemme, die dafür eingerichtet ist, mit einer zweiten extern der Umformerschaltung verlegten Anschlußleitung elektrisch verbunden zu werden, eine dritte Anschlußklemme, die dafür eingerichtet ist, mit einer dritten extern des

EP 2 936 686 B1

Umformerschaltungs verlegten Anschlußleitung elektrisch verbunden zu werden, sowie eine vierte Anschlußklemme, die dafür eingerichtet ist, mit einer vierten extern des Umformerschaltungs verlegten Anschlußleitung elektrisch verbunden zu werden, wobei der Spannungseingang der Energieversorgungsschaltung zwei Anschlußelektroden aufweist, von welchen Anschlußelektroden eine erste Anschlußelektrode an die dritte Anschlußklemme und eine zweite Anschlußelektrode an die vierte Anschlußklemme angeschlossen sind.

Ein Grundgedanke der Erfindung besteht darin, die Stromschnittstelle von Meßgerät-Elektroniken der in Rede stehenden Art bzw. der damit gebildeten Meßgeräte jeweils dadurch zu überprüfen, daß im Betrieb des jeweiligen Meßgeräts von der Stromschnittstelle für den damit des tatsächlich eingestellten Strompegel - beispielsweise automatisch und/oder veranlaßt durch einen entsprechenden Steuerbefehl - gelegentlich ein digitaler Stromwert, nämlich ein einen momentan eingestellten Strompegel des Signalstroms repräsentierender Meßwert, generiert und an den Mikroprozessor übermittelt wird, und daß mittels des Mikroprozessors - beispielsweise wiederum automatisch und/oder veranlaßt durch einen entsprechenden Steuerbefehl - nämlicher digitaler Stromwert mit dem dafür vorgegebenen, nämlich zuvor entsprechend an die Stromschnittstelle übermittelten Steuerwert verglichen wird, um so allfällige Veränderungen der der Stromschnittstelle immanenten Kennlinienfunktion, mithin daraus resultierenden Veränderungen der entsprechenden Umformerschaltung innewohnenden Umformerkennlinie möglichs frühzeitig erkennen zu können. Die Erfindung basiert u.a. auf der überraschenden Erkenntnis, daß der zur Ermittlung der digitaler Stromwerte erforderliche Analog-zu-Digitalwandler hinsichtlich seiner die Genauigkeit der Signalwandlung bestimmenden Kennwerte eine weitaus höhere Langzeitstabilität aufweisen kann, als die die Kennlinienfunktion der Stromschnittstelle bestimmenden Kennwerte des letztlich den Signalstrom auf den jeweils vom Mikroprozessor vorgegebene Stromstärkepegel einregelnde Stromreglers. Umgekehrt sind allfällige Diskrepanzen zwischen für die Meßgröße ermittelten Meßwerten und dafür schlußendlich eingestellten stationären Stromstärkepegel in überwiegendem Maße allein auf zeitlich änderndes Übertragungsverhalten nämlichen Stromreglers und/oder des diesem vorangeschalteten Digital-zu-Analog-Wandlers zurückzuführen, nicht aber auf ein gleichermaßen nennenswertes Driften des im Vergleich dazu als zeitinvariant anzusehenden Analog-zu-Digitalwandlers, wodurch dieser als Referenz bzw. als Vergleichsnormal für den tatsächlich eingestellten stationären Stromstärkepegel nutzbar ist.

Wenngleich also eine Realisierung des mittels der Stromschnittstelle gebildeten Regelkreises zum Einstellen des Stromstärkepegels des Signalstroms, nicht zuletzt aufgrund der für solche Stromschnittstellen zumeist geforderten sehr niedrigen Ansprechzeiten (bzw. umgekehrt hohen Dynamik), nach wie vor nennenswert auch mittels Komponenten der Analogtechnik, wie etwa Operationsverstärkern, Transistoren etc., erfolgt bzw. erfolgen muß, so kann nunmehr dennoch allfälliges Driften der Stromschnittstelle sehr schnell und sehr verläßlich mittels des Mikroprozessors, mithin mit "bordeigenen" Prüfmitteln, erkannt und ggf. auch durch eine passendes Nachführen der Rechenvorschrift für die Steuerwerte geeignet kompensiert werden. Darüberhinaus können beispielsweise aber auch allfällige Prüfintervalle zwischen den gelegentlich dennoch mittels externer Prüfmittel durchzuführenden Re-Kalibrierung erfindungsgemäßer Umformerschaltungen, etwa zwecks der Erfüllung behördlicher Vorschriften, gegenüber nämlichen Prüfintervallen bei konventionellen Umformerschaltungen nennenswert verlängert werden.

Für den Fall, daß mittels des Mikroprozessors eine außerhalb eines dafür vorgegebenen Toleranzbandes liegende Abweichung zwischen nämlichem digitalen Stromwert und dem jeweiligen Steuerwert festgestellt wird, kann dies zudem entsprechend zunächst signalisiert werden, beispielsweise visuell wahrnehmbar mittels eines vom Mikroprozessor angesteuerten Anzeigeelements des Meßgeräts quantitativ, etwa mit einer entsprechenden alphanumerischen Klartextanzeige, und/oder qualitativ, etwa mittels eines farbcodiertes Licht abgebenden und/oder entsprechend blinkenden Leuchtmittels. Darüberhinaus kann für den Fall, daß eine zu hohe, nämlich eine eine Nachjustierung der Umformerschaltung erfordernde Abweichung zwischen Strom- und Steuerwert festgestellt ist, mittels des Mikroprozessors, nämlich basierend auf dafür generierten Wertepaaren von digitalem Stromwert und jeweils zugehörigem Steuerwert, eine Neuberechnung der die für Generierung der Steuerwerte verwendeten Rechenvorschrift bestimmenden Koeffizienten erfolgen, derart, daß die mit der erneuerten Rechenvorschrift die die vorgenannten Abweichungen bewirkenden, beispielsweise alterungsbedingten, Veränderungen in der der Stromschnittstelle immanenten Kennlinienfunktion kompensiert werden, und/oder kann eine vorgezogene Re-Kalibrierung der jeweiligen Umformerschaltung mittels externer Prüfmittel automatisch veranlaßt werden.

Während die vorgenannte Überprüfung (Kalibrierung) der Stromschnittstelle bzw. der damit gebildeten Umformerschaltung ohne weiteres auch "on-the-fly", nämlich auch während des regulären Meßbetriebs durchführbar ist, kann im Falle, daß eine Nachjustierung der Umformerschaltung erforderlich geworden ist, gelegentlich auch ein Wechsel von einem dem normalen Meßbetrieb entsprechenden Normalbetriebsmodus in einen Sonderbetriebsmodus des Meßgeräts notwendig sein, beispielsweise derart, daß vom Mikroprozessor währenddessen am Steuerausgang ausschließlich solche Steuerwerte ausgegeben werden, die die Stromschnittstelle veranlassen, die Stromstärke des Signalstroms auf Stromstärkepegel außerhalb der vorgegebenen Meßspanne, beispielsweise auch in innerhalb eines für die Signalisierung von Alarmzuständen reservierten Bereichs, liegende, gleichwohl voneinander abweichende Strompegel einzuregeln.

Die Erfindung sowie weitere vorteilhafte Ausgestaltungen davon werden nachfolgend anhand von Ausführungsbeispielen näher erläutert, die in den Figuren der Zeichnung dargestellt sind. Gleiche Teile sind in allen Figuren mit denselben Bezugszeichen versehen; wenn es die Übersichtlichkeit erfordert oder es anderweitig sinnvoll erscheint, wird auf bereits erwähnte Bezugszeichen in nachfolgenden Figuren verzichtet. Weitere vorteilhafte Ausgestaltungen oder Weiterbildungen, insb. auch Kombinationen zunächst nur einzeln erläuterter Teilaspekte der Erfindung, ergeben sich ferner aus den Figuren der Zeichnung wie auch den Unteransprüchen an sich. Im einzelnen zeigen:

Fig. 1    schematisch eine, insb. für ein Meßgerät der industriellen Meß- und Automatisierunsgtechnik geeigneten, Umformerschaltung mit einer von einem Mikroprozessor angesteuerten Stromschnittstelle;

Fig. 2, 3    schematisch eine Varianten für ein Meßgerät der industriellen Meß- und Automatisierungstechnik mit einer Umformerschaltung gemäß Fig. 1; und

Fig. 4    eine Zusammenstellung von die Wirkungsweise der in Fig. 1 gezeigten Umformerschaltung schematisch illustrierenden Zeitreihen- bzw. Kennlinien-Diagrammen.

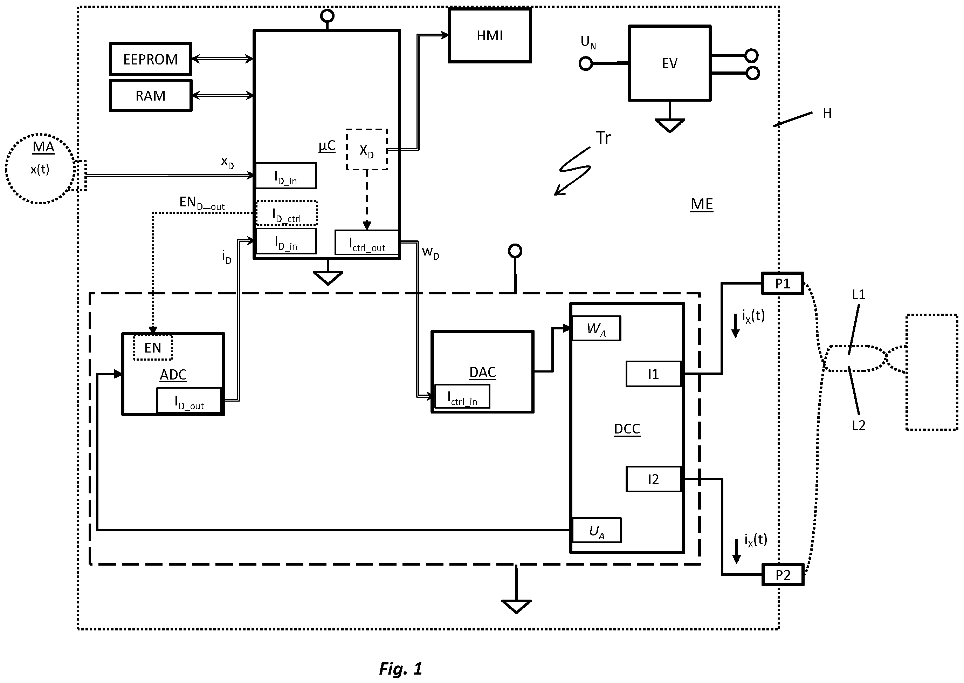

In der Fig. 1 ist schematisch nach Art eines Blockschaltbildes ein Ausführungsbeispiel für eine, insb. für die Verwendung in der industriellen Meß- und Automatisierungstechnik geeignetes, Meßgerät mit einem Meßaufnehmer MA und mit einer daran elektrisch angeschlossenen elektronischen, nämlich zumindest anteilig mittels Halbleiterelementen gebildeten, Meßgerät-Elektronik ME dargestellt. Die Meßgerät-Elektronikist ME in vorteilhafter Weise in einem entsprechenden, insb. schlag- und/oder auch explosionsfest und/oder hermetisch dicht ausgebildeten und/oder modular aufgebauten, Elektronik-Gehäuse H untergebracht. Das Elektronik-Gehäuse H kann beispielsweise vom Meßaufnehmer entfernt angeordnet oder, wie in Fig. 1 schematisch angedeutet, unter Bildung eines einzigen Kompaktgeräts direkt am Meßaufnehmer MA, beispielsweise von außen an einem den Meßaufnehmer MA einhausenden Aufnehmer-Gehäuse fixiert sein.

Der Meßaufnehmer MA dient dem Erfassen einer zeitlich veränderlichen physikalischen und/oder chemischen Meßgröße x, beispielsweise einer Dichte, einer Viskosität einer Temperatur und/oder einem Druck eines Fluids, einer Volumendurchflußrate bzw. einer Massendurchflußrate eines in einer Leitung, insb. einer Rohrleitung oder einem Gerinne, strömenden Fluids oder einem Füllstand eines in einem Behälter, insb. in einem Tank oder einem Becken, vorgehaltenen Mediums, insb. einer Flüssigkeit oder einem Schüttgut, sowie dem Generieren wenigstens eines einen zeitlichen Verlauf nämlicher Meßgröße x repräsentierenden - zunächst analogen - Meßsignals, das wiederum mittels der Meßgerät-Elektronik ME zunächst in ein dieses, mithin einen zeitlichen Verlauf nämlicher Meßgröße x, repräsentierendes digitales Meßsignal gewandelt und hernach zwecks der Generierung von die Meßgröße x repräsentierenden - digitalen - Meßwerten $X_D$ ausgewertet wird. Die Meßgröße x selbst ist naturgemäß zeitlich veränderlich, nämlich derart, daß sie sich während des störungsfreien Betriebs der mittels des jeweiligen Meßgeräts gebildete Meßstelle lediglich innerhalb eines, insb. für die Meßstelle bzw. das jeweilige Meßgerät spezifisch, vorgegebenen Meßbereichs $\Delta x_{12}$ ändert, der sich von einer durch einen vorgegebenen kleinsten Meßwert für Meßgröße x bestimmten Bereichsuntergrenze $x_1$ und einer durch einen vorgegebenen größten Meßwert für Meßgröße x bestimmten Bereichsobergrenze $x_2$ erstreckt. Eine außerhalb nämlichen Meßbereichs liegende Meßgröße würde dementsprechend als eine Störung der Meßstelle eingestuft.

Die Meßgerät-Elektronik ME ist ferner dafür vorgesehen, basierend auf dem digitalen Meßsignal bzw. den daraus abgeleiteten Meßwerten, ein von nämlichem digitalen Meßsignal abhängiges analoges Meßwertsignal mit einem Signalstrom zu generieren, von dem eine Stromstärke $I_x$ einen Meßwert X für die Meßgröße repräsentiert; dies im besonderen in der Weise, daß ein stationärer Stromstärkepegel $I_{x,j}$ nämlicher Stromstärke $I_x$ jeweils innerhalb einer dafür vorgegebenen Meßspanne $\Delta I_{12}$ liegen. Die Meßspanne $\Delta I_{12}$ korrespondiert hierbei mit dem für die Meßgröße x vorgegebenen Meßbereich $\Delta x_{12}$ und weist daher eine der Bereichsuntergrenze $x_1$ entsprechende erste Grenzstromstärke $I_1$ sowie eine mit der Bereichsobergrenze $x_2$ entsprechende- selbstreden von der Grenzstromstärke $I_1$ verschiedene - zweite Grenzstromstärke $I_2$ auf. Eine kleinste der beiden Grenzstromstärke $I_1$, $I_2$ entspricht hierbei einem - gelegentlich auch als Life-Zero-Wert bezeichntene - stromführenden Nullpunkt der Umformerschaltung. Das Meßwertsignal kann beispielsweise einem in der industriellen Meß- und Automatisierungstechnik häufig verwendeten 4 mA-20 mA-Stromsignal entsprechen, mithin ein in einem die Meßgerät-Elektronik umfassenden Signalstromkreis fließender Signalstrom sein, der innerhalb einer Meßspanne verläuft, deren Grenzstromstärke $I_1$ 4 mA oder weniger, möglichst aber mehr als 3,6 mA beträgt, und deren Grenzstromstärke $I_2$ 20 mA oder mehr, möglichst aber weniger als 21 mA, beträgt. Außerhalb der Meßspanne liegende Stromstärkepegel können ferner zur Signalisierung von Sonderbetriebszuständen, insb. auch von durch Störungen veranlaßten Alarmzuständen, dienen.

Zum Wandeln des digitalen Meßsignals $x_D$ in das analoge Meßwertsignal umfaßt die Meßgerät-Elektronik ME eine - beispielsweise als ein der eingangs erwähnten NAMUR-Empfehlung NE43:18.01.1994 genügender digitaler Meßumformer mit analogem Ausgangssignal ausgebildete - Umformerschaltung Tr mit einer Stromschnittstelle DCC und mit einem nämliche Stromschnittstelle steuernden Mikroprozessor $\mu$C, dem das digitale Meßsignal $x_D$ an einem Meßsignaleingang zugeführt ist. Der Mikroprozessor $\mu$C ist u.a. dafür eingerichtet, basierend auf dem digitalen Meßsignal $x_D$ an seinem Meßsignaleingang eine Meßwertefolge, nämlich eine einen zeitlichen Verlauf der Meßgröße repräsentierende Sequenz von für verschiedene Zeitpunkte $t_i$ gewonnenen, die Meßgröße jeweils momentan repräsentierenden digitalen Meßwerten $X_{D,i}$ zu generieren.

Die mittels der Umformerschaltung Tr generierten Meßwerte können beispielsweise vor Ort, nämlich direkt an der Meßstelle bzw. in deren unmittelbaren Nähe, angezeigt werden. Zum Visualisieren von Meßgerät intern erzeugten Meßwerten und/oder gegebenenfalls Meßgerät intern generierten Systemstatusmeldungen, wie etwa einer Fehlermeldung oder einem Alarm, vor Ort kann das Meßgerät beispielsweise Meßgerät-Elektronik kommunizierendes, insb. ein vom Mikroprozessor angesteuertes und/oder portables, Anzeige- bzw. Anzeige- und Bedienelement HMI aufweisen, wie etwa ein im Elektronik-Gehäuse H hinter einem darin entsprechend vorgesehenen Fenster plaziertes LCD-, OLED- oder TFT-Display sowie eine entsprechende Eingabetastatur und/oder ein Touchscreen. In vorteilhafter Weise kann die, beispielsweise auch fernparametrierbare, Meßgerät-Elektronik ferner so ausgelegt sein, daß sie im Betrieb des Meßgeräts mit einem diesem übergeordneten elektronischen Datenverarbeitungssystem, beispielsweise einer speicherprogrammierbaren Steuerung (SPS), einem Personalcomputer und/oder einer Workstation, via Datenübertragungssystem, beispielsweise einem Ethernet, einem Feldbus und/oder drahtlos per Funk, Meß- und/oder andere Betriebsdaten, ggf. auch in Echtzeit, austauschen kann, wie etwa aktuelle Meß- und/oder Systemdiagnosewerte oder der Steuerung des Meßgeräts dienende Einstellwerte. Des weiteren weist die Meßgerät-Elektronik ME ferner eine von einer externen Energieversorgung gespeiste Energieversorgungsschaltung EV mit einem, zwei Anschlußelektroden aufweisenden, Eingang und mit wenigstens einem Ausgang auf, die dazu dient, an nämlichem Ausgang eine Nutzspannung $U_N$ zum Betreiben der Stromschnittstelle DCC bzw. des Mikroprozessors $\mu$C, mithin zum Betreiben der damit gebildeten Meßgerät-Elektronik, bzw. eine entsprechende elektrische Nutzleistung für die Meßgerät-Elektronik bereitzustellen.

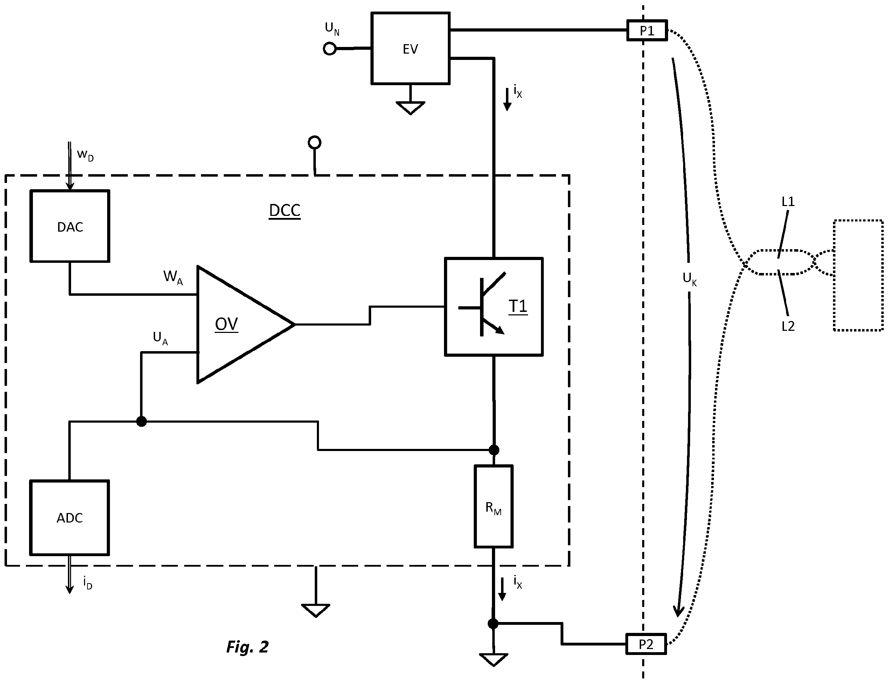

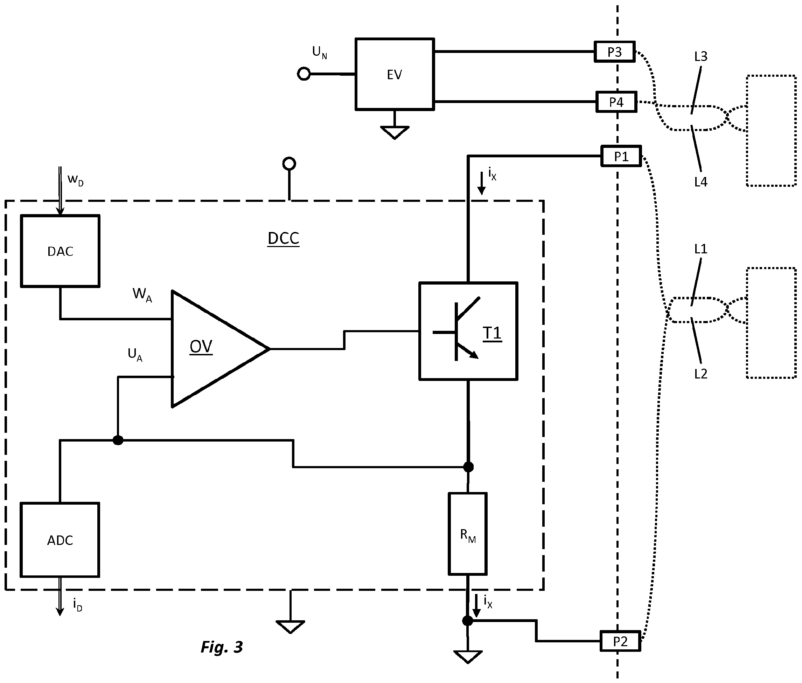

Die Stromschnittstelle DCC wiederum weist einen Stromausgang für den Signalstrom, einen Steuereingang $I_{ctrl\_in}$ sowie einen Stromsignalausgang $I_{D\_out}$ auf und ist dafür eingerichtet, im Betrieb den Signalstrom durch den Stromausgang fließen zu lassen und währenddessen sowohl die Stromstärke des Signalstroms auf einen einem am Steuereingang $I_{ctrl\_in}$ momentan angelegten Steuerwert $W_{D,j}$ entsprechenden stationären Stromstärkepegel $I_x$ einzuregeln als auch am Stromsignalausgang $I_{D\_out}$ eine Stromwertefolge $i_D$ auszugeben. Die Stromwertefolge $i_D$ ist eine Sequenz von für verschiedene, z.B. auch äquidistante, (Abtast-) Zeitpunkte $t_j$ gewonnenen, die Stromstärke bzw. den dafür eingestellten Stromstärkepegel $I_x$ jeweils momentan repräsentierenden digitalen Stromwerten $I_{D,j}$ und bildet somit einen zeitlichen Verlauf des Signalstroms $i_x$ nach. Wie in den Fig.2 und 3 schematisch dargestellt, kann die Stromschnittstelle, wie bei Meßgeräten der in Rede stehenden Art durchaus üblich, mittels eines von einem Operationsverstärker OV angesteuerten Transistor T1, beispielsweise einem Bipolar-Transistor oder einem FeldeffektTransistor, und einem im Betrieb den gesamten Signalstrom führenden und eine dazu proportionale Meßspannung $U_A$ für den Operationsverstärker liefernden Meßwiderstand $R_M$, mithin hier ausschließlich in Analogtechnik realisierten, linearen Stromreglers gebildet sein. Nämliche Meßspannung $U_A$ ist zudem an einen Analogeingang eines Analog-zu-Digital-Wandlers ADC geführt, von dem ein Digitalausgang wiederum der Realisierung des Stromsignalausgang $I_{D\_out}$ der Stromschnittstelle DCC dient. Der Steuereingang $I_{ctrl\_in}$ der Stromschnittstelle DCC kann, wie in Fig. 2 bzw. 3 schematisch dargestellt, beispielsweise mittels eines in der Stromschnittstelle integrierten Digital-zu-Analog-Wandler DAC gebildet sein, der an einem Digitaleingang den momentanen Steuerwert $W_{D,j}$ empfängt und in eine dementsprechende analoge Gleichspannung $W_A$ für den erwähnten Stromregler an einem Analogausgang umsetzt. Nämlicher Digital-zu-Analog-Wandler DAC kann z.B. ein nach einem Zählverfahren arbeitender 1-Bit-Wandler sein, bei dem also als analoge Gleichspannung $W_A$ ein arithmetische Mittelwert einer mit einem dem momentanen Steuerwert $W_{D,j}$ entsprechenden Tastgrad pulsweitenmodulierten Rechteckspannung dient.

Zum Einbinden der Umformerschaltung Tr, mithin des damit gebildeten Meßgeräts in einen schlußendlich den Signalstrom führenden Signalstromkreis weist die Umformerschaltung Tr eine erste Anschlußklemme P1 sowie eine zweite Anschlußklemme P2 auf. Jeder der beiden Anschlußklemmen P1, P2 ist dafür vorgesehen, mit einer von zwei extern der Umformerschaltung verlegten Anschlußleitungen L1 bzw. L2 elektrisch verbunden zu werden. Darüberhinaus weist der Stromausgang der Stromschnittstelle dementsprechend zwei Anschlußelektroden auf, von denen eine erste Anschlußelektrode I1 mit der Anschlußklemme P1 (und dementsprechend auch mit der Anschlußleitung L1) bzw. eine zweite Anschlußelektrode I2 mit der Anschlußklemme P2 (und dementsprechend auch mit der Anschlußleitung L2) elektrisch verbunden sind. Das Meßgerät kann hierbei z.B. als sogenanntes Zweileiter-Meßgerät, nämlich lediglich mittels der zwei Anschlußleitungen L1, L2 mit einem externer elektronischen Datenverarbeitungssystem elektrisch verbindbares, im Betrieb allein über nämliche zwei Anschlußleitungen L1, L2 mit elektrischer Energie versorgtes Meßgerät ausgebildet sein, derart, daß die Energieversorgungschaltung EV, wie in Fig. 2 schematisch dargestellt, mit zumindest einer der beiden Anschlußelektroden P1, P2 elektrisch direkt verbunden ist und eine für den Betrieb der Meßgerät-Elektronik, einschließlich des daran elektrisch angeschlossen Meßaufnehmers, erforderliche elektrische Nutzleistung aus einer vom Signalstrom $i_x$ sowie einer über den Anschlußklemmen P1, P2 anliegenden Klemmenspannung $U_K$ abhängigen bereitgestellten elektrischen Leistung bezieht. Demnach ist die Energieversorgungschaltung EV gemäß einer weiteren Ausgestaltung der Erfindung ferner dafür eingerichtet, zumindest einem Anteil des Signalstroms zu führen und dazu zu verwenden, die Nutzspannung $U_N$ bereitzustellen. Alternativ dazu kann das Meßgerät aber z.B. auch sogenanntes Vierleiter-Meßgerät ausgebildet sein, derart, daß die interne Energieversorgungsschaltung EV der Meßgerät-Elektronik ME, wie auch in Fig. 3 schematisch dargestellt, mittels eines zusätzlichen Paares Anschlußleitungen L3, L4 mit einer externen Energieversorgung verbunden ist und die für den Betrieb der Meßgerät-Elektronik, einschließlich des daran elektrisch angeschlossen Meßaufnehmers, benötigte elektrische Leistung über diese - im Betrieb nicht den Signalstrom $i_x$ führenden - Anschlußleitungen L3, L4 bezogen wird. Dafür weist die Meßgerät-Elektronik nach einer anderen Ausgestaltung der Erfindung zusätzlich zu den beiden erwähnten Anschlußklemmen P1, P2 eine dritte Anschlußklemme P3, die dafür eingerichtet ist, mit einer dritten extern des Umformerschaltungs verlegten Anschlußleitung L3 elektrisch verbunden zu werden, sowie eine vierte Anschlußklemme P4, die dafür eingerichtet ist, mit einer vierten extern des Umformerschaltungs verlegten Anschlußleitung L4 elektrisch verbunden zu werden, auf. Ferner sind bei dieser Ausgestaltung der Spannungseingang der Energieversorgungsschaltung mit eine erste Anschlußelektrode an die Anschlußklemme P3 und mit einer zweiten Anschlußelektrode an die Anschlußklemme P4 angeschlossen. Während für letzteren Fall, kann die Stromschnittstelle DCC entweder als passive oder aber auch aktive Schnittstelle ausgebildet sein; für den anderen Fall, daß nämlich das Meßgerät als ein Zweileiter-Meßgerät ausgebildet ist, ist die Stromschnittstelle DCC passiv.

Zum Ansteuern der Stromschnittstelle DCC ist im Mikroprozessor μC ferner ein mit deren Steuereingang $I_{ctrl\_in}$ verbundenen, beispielsweise mittels eines Steuerausgang $I_{ctrl\_out}$ vorgesehen und ist der Mikroprozessor ferner dafür eingerichtet, basierend auf der Meßwertefolge eine Steuerwertefolge $w_D$, nämliche eine Sequenz von digitalen Steuerwerten $W_{D,j}$ für die Stromschnittstelle zu generieren, von welchen Steuerwerten $W_{D,j}$ jeder jeweils einen mittels der Stromschnittstelle DCC einzustellen Stromstärkepegel momentan repräsentiert, und am Steuerausgang $I_{ctrl\_out}$ auszugeben. Zum Speichern von im Betrieb generierten digitalen Meß- und/oder Steuerwerten ist der Mikroprozessor μC desweiteren mit einem flüchtigen Datenspeicher RAM der Umformerschaltung verbunden. Den Mikroprozessor steuernde Ablaufprogramme, nicht zuletzt auch der Generierung der der Sollwertefolge dienende Rechenprogramme bzw. Teile davon, sind darüberhinaus in einem weiteren, mittels des Mikroprozessor μC ausles- und beschreibbaren, persistenten Datenspeicher EEPROM der Umformerschaltung Tr vorgehalten.

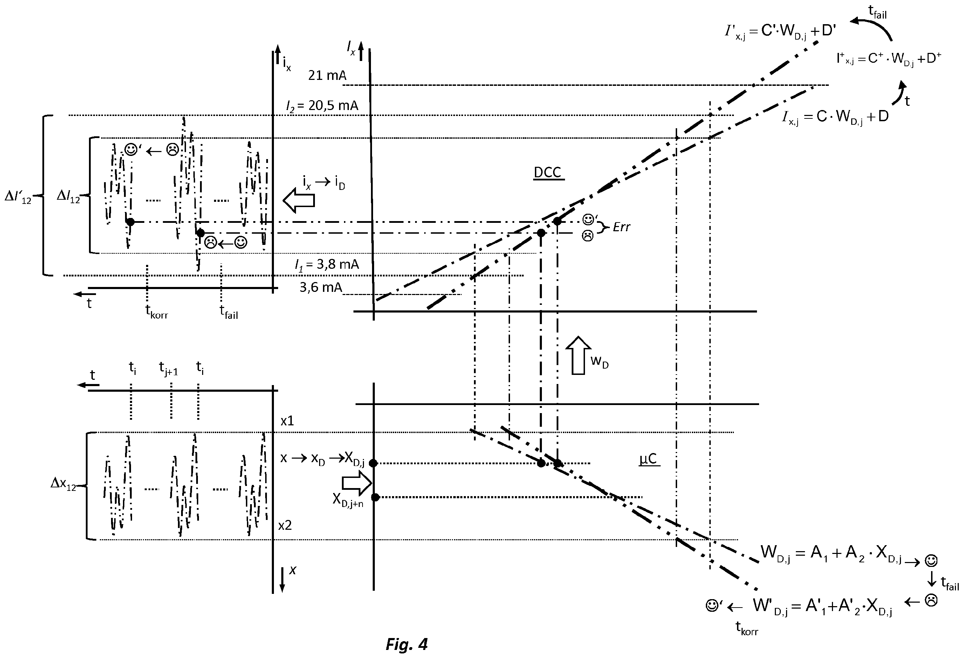

Wie in der Fig. 4 schematisch dargestellt, wohnt der Stromschnittstelle DCC eine - nicht zuletzt auch durch das Betriebsverhalten der nämliche Stromschnittstelle bildenden einzelnen elektronischen Komponenten bzw. Baugruppen bestimmte - Kennlinienfunktion inne, gemäß der Stromschnittstelle den jeweils aktuellen Steuerwert $(W_{D,j} = W_{D,0})$ in einen entsprechenden Stromstärkepegel umsetzt bzw. gemäß der jeder der stationären Stromstärkepegel des eingestellten Signalstroms $i_x$ von jeweils einem zugehörigen Steuerwert am Steuereingang $I_{ctrl\_in}$ abhängig ist. Die Kennlinienfunktion der Stromschnittstelle ist idealerweise eine lineare, nämlich idealerweise lediglich zunächst, nämlich bei Inbetriebnahme des installierten Meßgeräts, durch die beiden Kenngrößen Steigung C und Nullpunkt D bestimmte, Funktion, etwa in der Form:

$$I_{x,j} = C \cdot W_{D,j} + D \, ,$$

bzw. kann, nachdem in solchen Stromschnittstellen regelmäßig auch gewisse Abhängigkeiten des tatsächlich eingestellten Stromes auch von Temperatur- bzw. von effektiven Strombelastungen, mithin Abhängigkeit von mehreren Einflußgrößen, und/oder in geringem Maße auch nichtlineare bzw. zeitliche Abhängigkeiten vom aktuellen Steuerwert auftreten können, zum Zwecke der Modellierung der jeweiligen Stromschnittstellen zunächst mit ausreichender Genauigkeit als linear angenommen werden.

Der Mikroprozessor wiederum ermittelt die Steuerwerte $W_{D,j}$ der Steuerwertefolge als ein Funktionswert einer Funktion wenigstens eines der digitalen Meßwerte $X_{D,j}$ der Meßwertefolge, nämlich basierend auf dem wenigstens einen zuvor ermittelten (momentanen) Meßwert sowie einer von wenigstens zwei vorgegebenen, momentan gültigen - im Mikroprozessor μC entsprechend vorgehaltene bzw. im Datenspeicher EEPROM abgespeicherten - Koeffizienten $A_1,...,$ $A_N$ bestimmten Rechenvorschrift. Als Rechenvorschrift kann beispielsweise eine Polynomfunktion

$$W_{D,j} = \sum_{k=1}^{N} A_k \cdot X_{D,j}^{k-1} = A_1 + A_2 \cdot X_{D,i} + ... + A_N \cdot X_{D,j}^{N-1}$$

dienen. Die Koeffizienten $A_1,..., A_N$ - für die ein ursprünglicher Satz beispielsweise vom Hersteller der Meßgerät-Elektronik bzw. dem damit gebildeten Meßgerät vor dessen Auslieferung durch Einmessen mit einer, ggf. auch akkreditierten, Meß- und Prüfanordnung ermittelt und in einem nichtflüchtigen Datenspeicher, wie etwa dem Datenspeicher EEPROM, hinterlegt werden kann - sind hierbei so gewählt, daß der jeweilige Meßwert $X_{D,j}$ gemäß einer sich aus dem Zusammenspiel von Mikroprozessor und Stromschnittstelle insgesamt ergebenden Umformerkennlinie der Umformerschaltung

$$I_{x,j} = C \cdot \left( \sum_{k=1}^{N} A_k \cdot X_{D,j}^{k-1} \right) + D$$

in einen dazu passenden, nämlich jeweils vorab entsprechend vereinbarten, stationären Stromstärkepegel gewandelt wird. Hierbei kann es durchaus von Vorteil sein, zumindest den ursprünglichen Satz Koeffizienten $A_1,..., A_N$ mit einem Passwort geschützt im Mikroprozessor abzuspeichern, um so ein ungewolltes Löschen von Koeffizienten $A_1,..., A_N$ zu verhindern bzw. jederzeit ein Zurücksetzen des Mikroprozessors auf nämlichen ursprünglichen Satz Koeffizienten $A_1,..., A_N$ zu ermöglichen.

Nach einer Ausgestaltung der Erfindung ist der Mikroprozessor $\mu C$ im besonderen auch dafür eingerichtet, die Steuerwerte $W_{D,j}$ der Steuerwertefolge als eine lineare Funktion eines der digitalen Meßwerte $X_{D,j}$ der Meßwertefolge, nämlich basierend auf einer von genau zwei vorgegebenen, momentan gültigen Koeffizienten $A_1$, $A_2$ bestimmten Polynomfunktion:

$$W_{D,j} = \sum_{k=1}^{N=2} A_k \cdot X_{D,j}^{k-1} = A_1 + A_2 \cdot X_{D,j},$$

mithin einer Polynomfunktion vom Polynomgrad, $N-1 = 1$, zu ermitteln, derart also, daß die Umformer-Kennlinie in der Form:

$$I_{x,j} = C \cdot \left( A_1 + A_2 \cdot X_{D,j} \right) + D$$

definiert ist. Bei Stromschnittstellen mit denen der Signalstrom proportional zum zu signalisierenden Meßwert eingestellt werden soll, sind die Koeffizienten ferner in vorteilhafter Weise so gesetzt, daß im Ergebnis jeder stationäre Stromstärkepegel $I_{x,j}$ des eingestellten Signalstroms $i_x$ während des Normalbetriebs, mithin bei lediglich innerhalb des vorgegebenen Meßbereichs $\Delta x_{12}$ schwankender Meßgröße x, die Bedingung:

$$I_{x,j} = X_{D,j} \cdot \frac{I_2 - I_1}{x_2 - x_1} = X_{D,j} \cdot \frac{\Delta I_{12}}{\Delta x_{12}}$$

erfüllt.

Die Umformerschaltung Tr ist, wie bereits angedeutet, u.a. dafür eingerichtet, zeitweise -idealerweise nämlich vorwiegend - in einem Normalbetriebsmodus betrieben zu werden, in dem die Meßgröße x lediglich innerhalb des dafür vorgegebenen Meßbereichs $\Delta x_{12}$ zeitlich ändert und in dem vom Mikroprozessor zudem auch lediglich solche Steuerwerte am Steuerausgang $I_{ctrl\_out}$ ausgegeben werden, die die Stromschnittstelle DCC veranlassen, passend zum jeweiligen Meßwert $X_{D,j}$, die Stromstärke $I_x$ des Signalstroms so zu regeln, daß die stationären Stromstärkepegel $I_{x,j}$ jeweils innerhalb der Meßspanne $\Delta I_{12}$ liegen, beispielsweise, wie in Fig. 4 schematisch dargestellt, lediglich auf jeweils innerhalb einer sich zwischen etwa 3,8 mA und etwa 20,5 mA erstreckenden Meßspanne liegende Stromstärkepegel eingestellt werden. Darüberhinaus ist die Umformerschaltung ferner auch dafür eingerichtet, etwa veranlaßt durch eine - durch die Meßgerät-Elektronik selbst diagnostizierte - Störung der Umformerschaltung bzw. des digitalen Meßsignals und/oder veranlaßt durch eine - durch die Meßgerät-Elektronik selbst diagnostizierte - außerhalb des Meßbereichs liegenden Meßgröße und/oder veranlaßt durch eine - mittels der Meßgerät-Elektronik selbst diagnostizierte - unzulässig hohen Abweichung wenigstens eines der stationären Stromstärkepegel $I_{x,j}$ von dem dafür vorgegebenen Steuerwert $W_{D,j}$, zeitweise in einem Sonderbetriebsmodus betrieben zu werden, in dem vom Mikroprozessor am Steuerausgang, insb. ausschließlich, solche Steuerwerte ausgegeben werden, die die Stromschnittstelle veranlassen, die Stromstärke $I_x$ des Signalstroms so zu regeln, daß die stationären Stromstärkepegel $I_{x,j}$ außerhalb der vorgegebenen Meßspanne, $\Delta I_{12}$, insb. aber innerhalb eines für die Alarmierung reservierten bzw. in der eingangs erwähnten NAMUR-Empfehlung NE43:18.01.1994 dafür vorgeschlagenen, etwa unterhalb von 3,6 mA oder oberhalb von 21 mA festgelegten Strombereichs, liegen. Nach einer weiteren Ausgestaltung der Erfindung ist die Umformerschaltung Tr, mithin die die damit gebildete Meßgerät-Elektronik ME, ferner dafür eingerichtet, gelegentlich, beispielsweise im Falle einer selbst diagnostizierten Störung der Meßgerät-Elektronik bzw. der Meßgröße, automatisch vom Normalbetriebsmodus in den vorgenannten Sonderbetriebsmodus zu wechseln..

Wie bereits erwähnt, können Stromschnittstellen der in Rede stehenden Art, nicht zuletzt auch wegen ihres auch bei modernen Meßgeräten der industriellen Meß- und Automatisierungstechnik nach wie vor nennenswert in Analogtechnik realisierten Schaltungsaufbaus, dazu neigen, ihre von der Gesamtheit der an der Einstellung bzw. Regelung des Signalstromstrom beteiligten elektronischen Komponenten bzw. Baugruppen bestimmte, letztlich ein momentanes Übertragungsverhalten der jeweiligen Stromschnittstelle charakterisierende Kennlinienfunktion schleichend und/oder sukzessive zu ändern, derart, daß die jeweils aktuelle Kennlinienfunktion $I^+_{x,j} = C^+ \cdot W_{D,j} + D^+$, gemäß der die Stromschnittstelle die stationären Stromstärkepegel $I_{x,j}$ in Abhängigkeit von den digitalen Steuerwerten $W_{D,j}$ momentan einstellt, von der zuvor - beispielsweise beim Einmessen im Herstellerwerk oder bei einer in-situ, nämlich am in der Anlage installierten Meßgerät während dessen Inbetriebnahme durchgeführten (Nach-) Kalibrierung der Meßgerät-Elektroink - für die Stromschnittstelle ermittelbaren Kennlinienfunktion $I_{x,j} = C \cdot W_{D,j} + D$ abweicht, beispielsweise infolge einer zunehmenden Alterung der elektronischen Komponenten bzw. Baugruppen der Stromschnittstelle, mithin ändert sich auch die gesamte Umformer-Kennlinie, nämlich:

$$.. \; C \cdot \left( \sum_{k=1}^{N} A_k \cdot X_{D,j}^{k-1} \right) + D \rightarrow C^+ \cdot \left( \sum_{k=1}^{N} A_k \cdot X_{D,j}^{k-1} \right) + D^+ \quad \text{bzw.}$$

$$C \cdot \left( A_1 + A_2 \cdot X_{D,j} \right) + D \rightarrow C^+ \cdot \left( A_1 + A_2 \cdot X_{D,j} \right) + D^+$$

und demenstprechend auch der oben erwähnte - hier proportionale - Zusammenhang zwischen ermitteltem Meßwert $X_{D,j}$ und dafür aktuell eingestelltem Stromstärkepegel $I_{x,j}$, nämlich:

$$X_{D,j} \cdot \frac{\Delta I_{12}}{\Delta x_{12}} \rightarrow X_{D,j} \cdot \frac{\Delta I^+_{12}}{\Delta x_{12}} .$$

Somit paßt also die vormals korrekte, nämliche auf die ehemalige Kennlinienfunktion der Stromschnittstelle DCC seinerzeit exakt abgestimmte, Rechenvorschrift (☺) für die Steuerwerte in zunehmendem Maße immer weniger genau zur damit angesteuerten - inzwischen in ihrem Übertragungsverhalten veränderten - Stromschnittstelle DCC. Dies kann bei anhaltendem Fortschreiten nämlicher Änderung der Kennlinienfunktion auch dazu führen, daß eine Diskrepanz zwischen der aktuellen Rechenvorschrift und der momentanen Kennlinienfunktion zunächst immer größer wird und daraus resultierend eine Abweichung zwischen einem Steuerwert $W_{D,j}$ und dem dadurch veranlaßten stationären Stromstärkepegel $I_{x,j}$, mithin eine Abweichung zwischen einem Meßwert $W_{D,j}$ und dem korrespondierenden stationären Stromstärkepegel $I_{x,j}$ ab einem - regelmäßig nicht exakt vorhersag- oder bestimmbaren - Zeitpunkt $t_{fail}$ unzulässig hohe Ausmaße annimmt. Im Ergebnis führt diese Abweichung dazu, daß die aktuell gültige Rechenvorschrift nicht mehr zur aktuellen Kennlinienfunktion der Stromschnittstelle DCC paßt (☹), weil die danach ermittelten Steuerwerte jeweils einen Umformerfehler Err, nämliche eine Diskrepanz zwischen dem mit dem tatsächlich eingestellten stationären Stromstärkepegel $I_{x,j}$ angezeigten Meßwert und dem dem jeweils zugehörigen Steuerwert $W_{D,j}$ jeweils zugrunde liegenden Meßwert $X_{D,j}$, zur Folge haben, der unzulässig hoch, ggf. auch zu vermelden und/oder zu korrigieren ist. Der Umformerfehler Err kann beispielsweise gemäß der Formel:

$$Err = X_{D,j} \cdot \frac{\Delta I'_{12}}{\Delta x_{12}} - X_{D,j} \cdot \frac{\Delta I_{12}}{\Delta x_{12}}$$

quantitativ angegeben werden. Ab diesem Zeitpunkt $t_{fail}$ ist also die - zunächst ausreichend genau zur Stromschnittstelle passende - Rechenvorschrift als für die Stromschnittstelle bzw. deren momentane Kennlinienfunktion $C \cdot W_{D,j} + D \rightarrow C' \cdot W_{D,j} + D'$ bis auf weiteres nicht mehr passende Rechenvorschrift anzunehmen, mithin ist der mittels der Umformerschaltung, nämlich gemäß deren aktueller Umformer-Kennlinie:

$$I_{x,j} = C' \cdot \left( \sum_{k=1}^{N} A_k \cdot X_{D,j}^{k-1} \right) + D' \rightarrow I'_{x,j} ,$$

gelieferte Signalstrom $I_{x,j} \rightarrow I'_{x,j}$ als momentan fehlerhaft ( ☹ ) einzustufen.

Bei der erfindungsgemäßen Umformerschaltung Tr, mithin bei dem damit gebildeten erfindungsgemäßen Meßgerät, ist daher ferner vorgesehen, allfällige - nicht zuletzt auch mit fortschreitender Betriebsdauer bzw. Alterung der Stromschnittstelle DCC einhergehende - Veränderungen der Kennlinienfunktion der Stromschnittstelle DCC möglichst frühzeitig zu erkennen und ggf. zu vermelden und/oder durch geeignetes, nämlich mittels Mikroprozessor μC und der Stromschnittstelle DCC selbst realisiertes Nachführen der Rechenvorschrift für die Steuerwerte entsprechend zu kompensieren. Dafür weist der Mikroprozessor μC einen mit Stromsignalausgang $I_{D\_out}$ der Stromschnittstelle DCC elektrisch verbundenen Stromsignaleingang $I_{D\_in}$ auf. Zudem ist der Mikroprozessor μC der erfindungsgemäßen Umformerschaltung Tr dafür eingerichtet, basierend auf der Steuerwertefolge $w_D$ und der - via Stromsignaleingang $I_{D\_in}$ eingelesenen - Stromwertefolge $i_{D\_in}$, die Stromschnittstelle gelegentlich, insb. auch turnusmäßig wiederkehrend, zu überprüfen, nämlich zumindest zeitweise zu ermitteln, ob die momentane Kennlinienfunktion der Stromschnittstelle DCC nach wie vor zur aktuell für die Ermittlung der Steuerwerte gültigen, mithin vom Mikroprozessor μC für die Generierung der Steuerwerte ausgeführten, Rechenvorschrift paßt ( ☺ ), oder ob sich z.B. das Übertragungsverhalten der Stromschnittstelle DCC inzwischen derart drastisch verändert hat, daß der Umformerfehler *Err* unzulässig hoch, ggf. auch entsprechend zu vermelden und/oder zu korrigieren ist, mithin die aktuell gültige Rechenvorschrift nicht mehr zur aktuellen Kennlinienfunktion der Stromschnittstelle DCC paßt ( ☹' ), mithin die Stromschnittstelle bzw. deren Funktionstüchtigkeit zu überwachen.

Nämliches Überprüfen bzw. Überwachen der Stromschnittstelle DCC kann dadurch erfolgen, indem mittels des Mikroprozessors μC beispielsweise eine Abweichung zwischen einem einen mittels der Stromschnittstelle DCC einzustellen Stromstärkepegel momentan repräsentierenden Steuerwert $W_{D,j}$ und wenigstens einem zugehörigen digitalen Stromwert $I_{D,j}$ ggf. auch regelmäßig wiederkehrend, ermittelt und hernach festgestellt wird, ob die ermittelte Abweichung innerhalb bzw. außerhalb eines dafür vorgegebenen, zulässige Abweichungen repräsentierenden Toleranzbereichs liegt, und/oder indem mittels des Mikroprozessors μC berechnet wird, inwieweit bzw. um wieviel Prozent nämlicher Stromwert $I_{D,j}$ vom Steuerwert $W_{D,j}$, mithin vom davon repräsentierten Meßwert $X_{D,j}$ abweicht. Alternativ oder in Ergänzung können basierend auf einer zwei oder mehr, durch jeweils einen Steuerwert $W_{D,i}$ und einen jeweils zugehörigen Stromwert $I_{D,j}$ gebildete Wertepaare die jeweils aktuelle Kenngrößen Steigung C' und Nullpunkt D' der aktuellen - Kennlinienfunktion der Stromschnittstelle DCC zumindest näherungsweise mittels des Mikroprozessors μC ermittelt, und mit dafür zuvor ermittelten, beispielsweise im persistenten Datenspeicher EEPROM abgelegten, Referenzwerten C, D verglichen werden, etwa um festzustellen, ob bzw. inwieweit nämliche aktuelle Kennlinienfunktion von einer zuvor, beispielsweise im Zuge einer Kalibrierung im Herstellerwerk, für die Stromschnittstelle DCC ermittelten Kennlinienfunktion abweicht.

Nachdem eine solche Überprüfung der Stromschnittstelle DCC im Vergleich zu einer - etwa im Bereich von einigen wenigen Millisekunden liegenden - Wiederholrate, mit der die eigentlichen Meßwerte bzw. die Steuerwerte im Mikroprozessor generiert werden, als nicht zeitkritisch angesehen, mithin über einen viel größeren Zeitraum ausgedehnt werden kann, beispielsweise auch über einige Minuten, kann die Überprüfung der Umformerschaltung zunächst ohne weiteres auch während deren Normalbetriebsmodus erfolgen, beispielsweise auch in der Weise, daß zunächst, kontrolliert durch den Mikroprozessor, eine vorgegebene Anzahl von mittels Steuerwert $W_{D,i}$ und jeweils zugehörigem Stromwert $I_{D,j}$ gebildete Wertepaare zumindest vorübergehend, nämlich zumindest bis zum Abschluß der aktuelle durchzuführenden Überprüfung, im Datenspeicher EEPROM gespeichert und hernach zur vorgenannten Ermittlung der Kennlinienfunktion herangezogen werden. Hierbei kann es durchaus von Vorteil sein, den Steuerwert und wenigstens einen zugehörigen digitalen Stromwert, mithin das wenigstens eine damit gebildete Wertepaar zusammen mit einem Zeitstempel, nämliche einem Zeitwert, der mit einem Zeitpunkt des Speicherns korrespondiert, im Datenspeicher EEPROM abzuspeichern. Die, ggf. jeweils zusammen mit zugehörigem Zeitstempel, abgespeicherten Wertepaare und/oder die zwischen deren Stromwerten und dem jeweils zugehörigen Steuerwert ermittelten Abweichungen bzw. Umformerfehler *Err* können beispielsweise auch mittels des Anzeigeelements HMI vor Ort zur Anzeige gebracht werden, etwa auf einen entsprechend an den Mikroprozessor übermittelten Steuerbefehl hin und/oder nicht-flüchtig im Datenspeicher EEPROM abgespeichert werden, ggf. ebenfalls zusammen mit einem entsprechenden Zeitstempel.

In Anbetracht dessen, daß sich die Kennlinienfunktion der Stromschnittstelle DCC typischerweise nur sehr langsam zeitlich ändert, etwa auch im Vergleich zur vorgenannten Wiederholrate mit der die Meßwerte ermittelt werden bzw. im Vergleich zu typischen Änderungsraten der zu erfassenden Meßgröße, kann es durchaus genügen, wenn eine Überprüfung der Stromschnittstelle nur, wie bereits angedeutet, gelegentlich, beispielsweise zeitgesteuert und/oder auf Abruf, durchgeführt wird. Dementsprechend ist es aber durchaus auch möglich, den Stromsignalausgang $I_{D\_out}$ der Stromschnittstelle zu- bzw. abschaltbar auszubilden, derart, daß die Stromschnittstelle die Stromwertefolge $i_D$ am Stromsignalausgang $I_{IST\_out}$ erst nach Erhalt eines den Stromsignalausgang $I_{IST\_out}$ zuschaltenden, mithin aktivierenden Steuerbefehl ON auszugeben bzw. umgekehrt, daß die Stromschnittstelle zeitweise, z.B. bei Ausbleiben des Steuerbefehls ON, keine Stromwertefolge $i_D$ am Stromsignalausgang $I_{D\_out}$ ausgibt, hierfür kann der den Stromausgang bildende Analog-zu-Digitalwandler ADC ggf. auch insgesamt ausgeschaltet werden, etwa um die für den Betrieb der Umformerschaltung erforderliche elektrische Nutzleistung vorübergehend abzusenken und/oder um die ein Alterungsverhalten mitbestimmende Betriebszeit nämlichen Analog-zu-Digitalwandlers ADC so gering wie möglich zu halten. Dem Rechnung tragend kann es hierbei auch von Vorteil sein, eine Aktivierungszeit, nämlich eine über einen vorgegeben Betriebszeitraum kumulierte Gesamtzeit, während der die Stromschnittstelle die Stromwertefolge $i_D$ am Stromsignalausgang $I_{D\_out}$ ausgibt, kürzer auszubilden als eine Deaktivierungszeit, nämlich eine über einen vorgegeben Betriebszeitraum kumulierte Gesamtzeit, während der die Stromschnittstelle die Stromwertefolge $i_D$ am Stromsignalausgang $I_{D\_out}$ nicht ausgibt. Gemäß einer weiteren Ausgestaltung der Erfindung weisen dementsprechend, wie auch in Fig. 1 schematisch angedeutet, die Stromschnittstelle ferner einen Freigabeeingang EN und der Mikroprozessor einen mit nämlichem Freigabeeingang der Stromschnittstelle verbundenen Freigabeausgang $I_{out\_ctrl}$ auf. Die Stromschnittstelle ist ferner so ausgestaltet, daß die Stromwertefolge $i_D$ am Stromsignalausgang $I_{IST\_out}$ ausgegeben wird, nachdem ein den Stromsignalausgang $I_{IST\_out}$ aktivierender Steuerbefehl ON am Freigabeeingang EN angelegt ist. In entsprechender Weise ist Mikroprozessor ferner dafür eingerichtet, gelegentlich einen Steuerbefehl zum Aktivieren des Stromsignalausgangs $I_{IST\_out}$ zu generieren und am Freigabeausgang $I_{out\_ctrl}$ auszugeben. Ferner ist die Stromschnittstelle eingerichtet, keine Stromwertefolge $i_D$ am Stromsignalausgang $I_{D\_out}$ auszugeben, falls kein aktivierender Steuerbefehl ON am Freigabeeingang EN bzw. nachdem ein den Stromsignalausgang $I_{D\_out}$ deaktivierender Steuerbefehl OFF am Freigabeeingang EN angelegt ist. Für letzteren Fall kann der Mikroprozessor ferner auch so ausgestaltet sein, daß er gelegentlich auch einen Steuerbefehl zum Deaktivieren des Stromsignalausgangs $I_{D\_out}$ generiert und am Freigabeausgang $I_{out\_ctrl}$ ausgibt. Alternativ oder in Ergänzung zum zeitweisen Deaktivieren des Stromausgangs bzw. zum Abschalten des diesen bildende Analog-zu-Digitalwandler ADC kann die für den Betrieb der Umformerschaltung erforderliche elektrische Nutzleistung vorübergehend auch dadurch abgesenkt werden, indem ein nämlichen Analog-zu-Digitalwandler ADC steuerndes Taktsignal lediglich vorübergehend, beispielsweise während einer Überprüfung der Stromschnittstelle DCC, eine im Vergleich zu einer ansonsten eingestellten Grundtaktrate höhere Arbeitstaktrate aufweist.

Für den regelmäßig nicht auszuschließenden Fall, daß mittels des Mikroprozessors μC aufgrund einer während des Betriebs durchgeführten Überprüfung der Stromschnittstelle DCC gelegentlich festgestellt wird, daß die aktuell gültige Rechenvorschrift nicht mehr zur aktuellen Kennlinienfunktion der Stromschnittstelle DCC paßt (☹), mithin eine Überschreiten des Zeitpunktes $t_{fail}$ erkannt worden ist, kann dies zunächst zur Anzeige gebracht werden, beispielsweise auch vor Ort mittels des erwähnten Anzeigeelements HMI, um so zunächst den Bedarf an einer entsprechenden Korrektur von Einstellungen der Umformerschaltung lediglich zu vermelden. Alternativ oder in Ergänzung kann aber auch basierend auf vom Mikroprozessor generierten Steuerwerten sowie daraufhin von der Stromschnittstelle ausgegebenen und vom Mikroprozessor eingelesenen Stromwerten eine entsprechende Korrektur der Umformer-Kennlinie vorgenommen werden, um so den Umformerfehler *Err* entsprechend zu minimieren. Daher ist der Mikroprozessor μC nach einer weiteren Ausgestaltung der Erfindung ferner dafür eingerichtet ist, basierend auf der Steuerwertefolge $w_D$ und der Stromwertefolge $i_D$, insb. basierend auf gespeicherten Steuerwerten $W_{D,j}$ sowie gespeicherten digitalen Stromwerten $I_{D,j}$, die Rechenvorschrift für die Steuerwerte auf die aktuelle Kennlinienfunktion der Stromschnittstelle DCC hin abzugleichen, um so den Umformerfehler *Err* wieder - nämlich ab einem Zeitpunkt $t_{korr}$ - zu verringern; dies idealerweise auch so, daß eine Abweichung der aktuellen Kennlinienfunktion von einer zuvor für die Stromschnittstelle ermittelten Kennlinienfunktion möglichst vollständig kompensiert, und somit der Umformerfehler *Err* praktisch eliminiert wird.

Zum Zwecke der Korrektur der Umformer-Kennlinie ist nach einer weiteren Ausgestaltung der Erfindung ferner vorgesehen, daß der Mikroprozessor μC, nachdem eine zu hohe Abweichung eines stationären Stromstärkepegels $I_{x,j}$ von dem dafür vorgegebenen Steuerwert $W_{D,j}$, mithin ein zu hoher Umformerfehler *Err* bzw. eine Überschreiten des Zeitpunktes $t_{fail}$ festgestellt ist (☹), wenigstens einen Ersatz-Koeffizienten $A'_M$ für wenigstens einen der momentan gültigen gleichwohl zu ersetzenden Koeffizienten $A_M \in \{A_1,..., A_N\}$ ermittelt. Dies im besonderen in der Weise, daß im Ergebnis die korrigierte, nämlich mittels der nunmehr vom wenigstens einen Ersatz-Koeffizienten $A'_M \to A_M$ mitbestimmten Rechenvorschrift neu eingestellte Umformer-Kennlinie (☺') der ursprünglichen Umformer-Kennlinie möglichst exakt entspricht, mithin für die korrigierte bzw. die ursprüngliche Umformer-Kennlinie idealerweise:

$$C' \cdot \left(A'_1 + A'_2 \cdot X_{D,j}\right) + D' = C \cdot \left(A_1 + A_2 \cdot X_{D,j}\right) + D$$

gilt. Der wenigstens eine Ersatz-Koeffizient wird - gleichermaßen wie zuvor der nunmehr ersetzte Koeffizient - nichtflüchtig abgespeichert, beispielsweise also im Datenspeicher EEPROM, un d somit dem Mikroprozessor zur Verfügung gehalten. Nämliches Abspeichern des Ersatz-Koeffizienten kann ggf. wiederum in Verbindung mit einem entsprechenden Zeitstempel erfolgen. Zum Korrigieren der als unzulässige hohe Umformerfehler Errverursachenden Umformer-Kennlinie ist der Mikroprozessor gemäß einer weiteren Ausgestaltung der Erfindung ferner so eingerichtet, daß er gemäß der aktuellen, nämlich von den momentan gültigen Koeffizienten $A_1, ..., A_N$ bestimmten, gleichwohl nicht mehr zur Stromschnittstelle passenden Rechenvorschrift zumindest zwei voneinander abweichende Steuerwerte $W_{D,j}$ bzw. $W_{D,j+n}$ ermittelt und zu unterschiedlichen Zeitpunkten $t_j$ bzw. $t_{j+n}$ am Steuerausgang $I_{ctrl\_out}$ ausgibt. Darüberhinaus ermittelt der Mikroprozessor anhand der während der Ausgabe der Steuerwerte $W_{D,j}$ bzw. $W_{D,j+n}$ Steuerausgang $I_{ctrl\_out}$ von der Stromschnittstelle entsprechend generierten Stromwertfolge am Stromsignalausgang $I_{D\_out}$ jeweils zugehörige, nämlich die von der Stromschnittstelle für Steuerwerte $W_{D,j}$ bzw. $W_{D,j+n}$ jeweils tatsächlich eingestellten stationären Stromstärkepegel repräsentierende, digitale Stromwerte $I_{D,j}$ und $I_{D,j+n}$. Basierend auf sowohl den wenigsten zwei Steuerwerten $W_{D,j}$ bzw. $W_{D,j+n}$ als auch den wenigstens zwei digitalen Stromwerte $I_{D,j}$ und $I_{D,j+n}$ ermittelt der Mikroprozessor schließlich wenigstens einen Ersatz-Koeffizienten $A'_M$ für wenigstens einen der momentan gültigen gleichwohl zu ersetzenden Koeffizienten $A_M \in \{A_1, ..., A_N\}$ um hernach, nämlich ab dem mit dem Vollzug der Änderung der Rechenvorschrift korrespondieren Zeitpunkt $t_{korr}$, die Steuerwertefolge $w_D$ unter Verwendung des wenigstens einen Ersatz-Koeffizienten $A'_M \rightarrow A_M$ anstelle des zu ersetzenden Koeffizienten $A_M$ zu generieren.

Für den typischen Fall, daß zum einen die momentane Kennlinienfunktion im wesentlichen einer linearen Funktion entspricht, mithin ausreichenden genau durch die Formel $I_{x,j} = C \cdot W_{D,j} + D$ approximiert ist, und daß zum anderen die Rechenvorschrift einer Polynomfunktion vom Polynomgrad Eins (N = 2) entspricht, mithin lediglich zwei Ersatz-Koeffizienten $A'_1$, $A'_2$ zu ermitteln sind, um die Umformerkennline zu korrigieren bzw. die Rechenvorschrift für die Steuerwerte an die momentane Kennlinienfunktion der Stromschnittstelle anzupassen, können die mittels des Mikroprozessors $\mu C$ auszuführende Berechnung des Ersatzkoeffizienten $A'_2 \rightarrow A_2$ entsprechend folgender Rechenvorschrift:

$$A'_2 = A_2 \cdot \frac{W_{D,j+n} - W_{D,j}}{I_{D,j+n} - I_{D,j}} \quad \left(n > 0 \ \& \ W_{D,j} \neq W_{D,j+n}\right)$$

bzw. die mittels des Mikroprozessors $\mu C$ auszuführende Berechnung des Ersatzkoeffizienten $A'_1 \rightarrow A_1$ entsprechend folgender Rechenvorschrift:

$$A'_1 = A_1 - \frac{1 - \dfrac{I_{D,j+n} - I_{D,j}}{W_{D,j+n} - W_{D,j}}}{1 - \dfrac{I_{D,j}}{W_{D,j}}} = A_1 - \frac{1 - \dfrac{A_2}{A'_2}}{1 - \dfrac{I_{D,j}}{W_{D,j}}} \quad \left(n > 0 \ \& \ W_{D,j} \neq W_{D,j+n}\right)$$

.

realisiert werden.

Für den Fall, daß die Meßgröße x im Vergleich zur erwähnten Wiederholrate, mit der die eigentlichen Meßwerte bzw. die Steuerwerte im Mikroprozessor generiert werden, regelmäßig sehr langsam bzw. über längere Zeiträume stationär ist, kann die Berechnung der vorgenannten Ersatzkoeffizienten $A'_M$ ($A'_1$, $A'_2$,..) durchaus auch während des Normalbetriebsmodus der Umformerschaltung Tr erfolgen. Für den anderen Fall, daß die Meßgröße x typischerweise erheblich schwankt bzw. allenfalls in nicht vorhersehbarer Weise oder nur für kurze Zeit stationär ist, kann es allerdings durchaus erforderlich sein, daß die Umformerschaltung Tr, nachdem ein Bedarf für eine Änderung der Rechenvorschrift diagnostiziert worden ist, veranlaßt wird, vom Normalbetriebsmodus in den Sonderbetriebsmodus zu wechseln, um den Ersatz-Koeffizienten $A'_M$ zu ermitteln. Nämlicher Wechsel vom Normal- in den Sonderbetriebsmodus kann beispielsweise von extern gesteuert, etwa durch einen an den Mikroprozessor via Anzeige- und Bedienelement HMI übermittelten Steuerbefehl, oder beispielsweise auch automatisch, nämlich durch den Mikroprozessor bei Vorliegen eines entsprechenden Diagnoseergebnisses selbsttätig und ohne Abwarten eines weiteren externen Steuerbefehls, ausgeführt werden. Zum Ermitteln des wenigstens eines Ersatz-Koeffizienten $A'_M$ können dann entsprechend zwei oder mehrere voneinander abweichende Steuerwerte vom Mikroprozessor $\mu C$ ausgegeben werden, von denen jeder die Stromschnittstelle DCC veranlaßt, die Stromstärke $I_x$ des Signalstroms so zu regeln, daß der jeweils zugehörige stationäre Stromstärkepegel $I_x$ außerhalb der Meßspanne $\Delta I_{12}$, mithin unterhalb einer niedrigsten der beiden Grenzstromstärken der Meßspanne oder aber oberhalb einer höchsten der beiden Grenzstromstärken der Meßspanne liegt, beispielsweise also 3,6 mA oder weniger bzw 21 mA oder mehr beträgt.

Bei der erfindungsgemäßen Umformerschaltung bzw. der damit gebildeten Meßgerät-Elektroniken ist eine weitere Möglichkeit, die Kennliniefunktion der Stromschnittstelle, die Rechenvorschrift für die Steuerwerte und/oder die Umformerkennlinie in-situ zu überprüfen zudem auch während der im Anschluß an die Installation des jeweiligen Meßgeräts in der Anlage vorgenommen (Erst-) Inbetriebnahme bzw. auch während einer (Wieder-) Inbetriebnahme nach einem Neustart des Mikroprozessors gegeben. Dies hat u.a. den Vorteil, daß währenddessen die Anlange ohnehin planmäßig bzw. kontrolliert ohne das durch die zu überprüfenden Meßgerät-Elektronik gebildete Meßgerät gefahren wird, mithin keine weitere, ggf. auvh unplanmäßige Störung des Betrieb der übrigen Anlage erforderlich ist. Dementsprechend ist die Umformerschaltung gemäß einer weiteren Ausgestaltung der Erfindung dafür eingerichtet, in einem Inbetriebnahmemodus betrieben zu werden, in dem der Mikroprozessor zunächst gestartet wird und hernach die Stromschnittstelle mittels des Mikroprozessors überprüft wird. Während des Inbetriebnahmemodus kann die Stromschnittstelle mittels des Mikroprozessors, selbstredend nachdem dieser gestartet worden ist, sehr einfach überprüft werden, indem am Steuerausgang zunächst, nämlich zu einem Zeitpunkt $t_j$, ein Life-Zero-Steuerwert, nämlich ein Steuerwert, der die Stromschnittstelle veranlaßt, die Stromstärke $I_x$ des Signalstroms so zu regeln, daß der zugehörige stationäre Stromstärkepegel $I_{x,j}$ einer den Life-Zero-Wert (stromführenden Nullpunkt der Umformerschaltung) signalisierenden Stromstärke entspricht, als auch zu einem späteren Zeitpunkt $t_{j+n}$, insb. nachdem der Mikroprozessor wenigstens einen dem Life-Zero-Steuerwert entsprechenden digitalen Stromwert eingelesen hat, einen vom Life-Zero-Steuerwert abweichenden Steuerwert, der die Stromschnittstelle veranlaßt, die Stromstärke $I_x$ des Signalstroms so zu regeln, daß der zugehörige stationäre Stromstärkepegel $I_{x,j+n}$ einem oberhalb des Life-Zero-Werts liegenden Stromwert, beispielsweise auch einem mehr als 20,5 mA und weniger als 23 mA betragenden Alarmstromwert, entspricht, ausgegeben werden und indem mittels des Life-Zero-Steuerwerts, mittels wenigstens eines nämlichem Life-Zero-Steuerwert entsprechenden digitalen Stromwerts, mittels des vom Life-Zero-Steuerwerts abweichenden Steuerwerts sowie mittels wenigstens eines nämlichem Steuerwert entsprechenden digitalen Stromwerts die aktuelle Kennlinienfunktion ermittelt und mit der ursprünglich vorgegebenen Kennlinienfunktion verglichen wird. Alternativ oder in Ergänzung dazu können zwecks der Überprüfung der Stromschnittstelle mittels des Mikroprozessors auch eine Abweichung zwischen Life-Zero-Steuerwert und dem zugehörigen digitalen Stromwert $I_{D,j}$ sowie eine Abweichung zwischen dem anderen vom Life-Zero-Steuerwert abweichenden Steuerwert und dem zugehörigen digitalen Stromwert $I_{D,j+n}$ ermittelt werden und kann hernach die Stromschnittstelle überprüft werden, indem mittels des Mikroprozessors festgestellt wird, ob jede der beiden ermittelten Abweichungen innerhalb bzw. außerhalb des erwähnten, zulässige Abweichungen repräsentierenden Toleranzbereichs liegt.

**Patentansprüche**

1. Umformerschaltung zum Wandeln eines einen zeitlichen Verlauf einer, insb. innerhalb eines vorgegebenen Meßbereichs, zeitlich veränderlichen physikalischen und/oder chemischen Meßgröße (x) repräsentierenden digitalen Meßsignals ($x_D$) in ein von nämlichem digitalen Meßsignal abhängiges analoges Meßwertsignal mit einem Signalstrom ($i_x$) von dem eine Stromstärke einen Meßwert (X) für die Meßgröße repräsentiert, welche Umformerschaltung umfaßt:

    - eine Stromschnittstelle (DCC)

        -- mit einem Steuereingang ($I_{ctrl\_in}$),
        -- mit einem Stromsignalausgang ($I_{D\_out}$), und
        -- mit einem Stromausgang ($I_1$, $I_2$); sowie

    - einen Mikroprozessor ($\mu$C)

        -- mit einem Meßsignaleingang für das digitale Meßsignal ($x_D$),
        -- mit einem mit dem Stromsignalausgang ($I_{D\_out}$) der Stromschnittstelle verbundenen Stromsignaleingang ($I_{D\_in}$) und
        -- mit einem mit dem Steuereingang ($I_{ctrl\_in}$) der Stromschnittstelle verbundenen Steuerausgang ($I_{ctrl\_out}$);

    - wobei die Stromschnittstelle dafür eingerichtet ist,

        -- den Signalstrom durch den Stromausgang fließen zu lassen
        -- und währenddessen
        --- sowohl die Stromstärke des Signalstroms ($i_x$) auf einen einem am Steuereingang ($I_{ctrl\_in}$) momentan angelegten Steuerwert ($W_{D,j}$) entsprechenden stationären Stromstärkepegel ($I_x$) einzuregeln, derart, daß

jeder der stationären Stromstärkepegel gemäß einer der Stromschnittstelle immanenten, insb. linearen, Kennlinienfunktion von jeweils einem zugehörigen Steuerwert abhängig ist,
   --- als auch am Stromsignalausgang ($I_{D\_out}$) eine Stromwertefolge ($i_D$), nämlich eine einen zeitlichen Verlauf der Stromstärke des Signalstroms ($i_x$) repräsentierende Sequenz von für verschiedene Zeitpunkte ($..., t_j, ..., t_{j+n}, ...$) gewonnenen, die Stromstärke momentan repräsentierenden digitalen Stromwerten ($I_{D,j}$), auszugeben; und

- wobei der Mikroprozessor ($\mu$C) dafür eingerichtet ist,

  -- basierend auf dem digitalen Meßsignal ($x_D$) am Meßsignaleingang, eine Meßwertefolge, nämlich eine einen zeitlichen Verlauf der Meßgröße repräsentierende Sequenz von für verschiedene Zeitpunkte (ti) gewonnenen, die Meßgröße jeweils momentan repräsentierenden digitalen Meßwerten ($X_{D,i}$) zu generieren, und
  -- basierend auf der Meßwertefolge eine Steuerwertefolge ($w_D$), nämliche eine Sequenz von digitalen Steuerwerten ($W_{D,j}$) für die Stromschnittstelle, zu generieren und am Steuerausgang auszugeben, und

- wobei der Mikroprozessor ($\mu$C) dafür eingerichtet ist, basierend auf der Steuerwertefolge ($w_D$) und der Stromwertefolge ($i_D$), insb. nämlich basierend auf zumindest vorübergehend gespeicherten Steuerwerten ($W_{D,j}$) sowie zumindest vorübergehend gespeicherten digitalen Stromwerten ($I_{D,j}$), die Stromschnittstelle zu überwachen und/oder zu überprüfen, insb. nämlich

  -- eine Abweichung zwischen einem Steuerwert ($W_{D,j}$) und wenigstens einem zugehörigen digitalen Stromwert ($I_{D,j}$) zu ermitteln
  -- und/oder festzustellen, inwieweit ein Stromwert ($I_{D,j}$) von einem zugehörigen Steuerwert ($W_{D,j}$) abweicht,
  -- und/oder eine aktuelle Kennlinienfunktion, gemäß der die Stromschnittstelle die stationären Stromstärkepegel ($I_{x,j}$) in Abhängigkeit von den digitalen Steuerwerten ($W_{D,j}$) einstellt, zu ermitteln
  -- und/oder festzustellen, ob bzw. inwieweit eine aktuelle Kennlinienfunktion, gemäß der die Stromschnittstelle die stationären Stromstärkepegel ($I_{x,j}$) in Abhängigkeit von den digitalen Steuerwerten ($W_{D,j}$) einstellt, von einer früheren Kennlinienfunktion der Stromschnittstelle abweicht;

- wobei die Umformerschaltung dafür eingerichtet ist, zeitweise, insb. vorwiegend, in einem Normalbetriebsmodus betrieben zu werden,

  -- in dem die Meßgröße ($x$) lediglich innerhalb eines dafür vorgegebenen Meßbereichs, $\Delta x_{12}$, mit einer durch einen vorgegebenen kleinsten Meßwert für Meßgröße ($x$) bestimmten Bereichsuntergrenze, $x_1$, und einer durch einen vorgegebenen größten Meßwert für Meßgröße ($x$) bestimmten Bereichsobergrenze, $x_2$, zeitlich ändert, und
  -- in dem vom Mikroprozessor lediglich solche Steuerwerte am Steuerausgang ausgegeben werden, die die Stromschnittstelle veranlassen, die Stromstärke, $I_x$, des Signalstroms so zu regeln, daß die stationären Stromstärkepegel ($I_{x,j}$) jeweils innerhalb einer dafür vorgegebenen, nämlich mit dem für die Meßgröße ($x$) vorgegebenen Meßbereich, $\Delta x_{12}$, korrespondierenden, mithin eine mit dessen Bereichsuntergrenze, $x_1$, korrespondierende erste Grenzstromstärke, $I_1$, sowie eine mit dessen Bereichsobergrenze, $x_2$, korrespondierende, von der ersten Grenzstromstärke verschiedene zweite Grenzstromstärke, $I_2$, aufweisenden Meßspanne, $\Delta I_{12}$, liegen;

- **gekennzeichnet dadurch, dass** die Umformerschaltung dafür eingerichtet ist - veranlaßt durch eine unzulässig hohe Abweichung wenigstens eines der stationären Stromstärkepegel ($I_{x,j}$) von dem dafür vorgegebenen Steuerwert ($W_{D,j}$) - zeitweise in einem Sonderbetriebsmodus betrieben zu werden, in dem vom Mikroprozessor am Steuerausgang, insb. ausschließlich, solche Steuerwerte ausgegeben werden, die die Stromschnittstelle veranlassen, die Stromstärke, $I_x$, des Signalstroms so zu regeln, daß die stationären Stromstärkepegel ($I_{x,j}$) außerhalb der vorgegebenen Meßspanne, $\Delta I_{12}$, liegen.

2. Umformerschaltung nach dem vorherigen Anspruch, weiters umfassend: einen flüchtigen Datenspeicher (RAM) zum Speichern von digitalen Meßwerten und/oder digitalen Steuerwerten, wobei der Mikroprozessor dafür eingerichtet ist, digitale Steuerwerte ($W_{D,j}$) sowie digitale Stromwerte ($I_{D,j}$) vorübergehend im Datenspeicher zu speichern.

3. Umformerschaltung nach einem der vorherigen Ansprüche, wobei der Mikroprozessor dafür eingerichtet ist, basierend auf der Steuerwertefolge ($w_D$) und der Stromwertefolge ($i_D$), insb. basierend auf zumindest vorübergehend gespeicherten Steuerwerten ($W_{D,j}$) sowie zumindest vorübergehend gespeicherten digitalen Stromwerten ($I_{D,j}$), die Stromschnittstelle zu überprüfen, nämlich

- eine Abweichung zwischen einem Steuerwert ($W_{D,j}$) und wenigstens einem zugehörigen digitalen Stromwert ($I_{D,j}$) zu ermitteln; und/oder
- festzustellen, inwieweit nämlicher Stromwert ($I_{D,j}$) vom Steuerwert ($W_{D,j}$) abweicht; und/oder
- eine aktuelle Kennlinienfunktion, gemäß der die Stromschnittstelle die stationären Stromstärkepegel ($I_{x,j}$) in Abhängigkeit von den digitalen Steuerwerten ($W_{D,j}$) einstellt, zu ermitteln; und/oder
- festzustellen, ob bzw. inwieweit eine aktuelle Kennlinienfunktion, gemäß der die Stromschnittstelle die stationären Stromstärkepegel ($I_{x,j}$) in Abhängigkeit von den digitalen Steuerwerten ($W_{D,j}$) einstellt, von einer zuvor für die Stromschnittstelle ermittelten Kennlinienfunktion abweicht.

4. Umformerschaltung nach einem der vorherigen Ansprüche,

- wobei die Stromschnittstelle einen Freigabeeingang (EN) und der Mikroprozessor einen mit nämlichem Freigabeeingang der Stromschnittstelle verbundenen Freigabeausgang ($I_{out\_ctrl}$) aufweisen,
- wobei die Stromschnittstelle dafür eingerichtet ist, die Stromwertefolge ($\overline{i_D}$) am Stromsignalausgang ($I_{IST\_out}$) auszugeben, nachdem ein den Stromsignalausgang ($I_{IST\_out}$) aktivierender Steuerbefehl (ON) am Freigabeeingang (EN) angelegt ist und der Mikroprozessor dafür eingerichtet ist, einen Steuerbefehl zum Aktivieren des Stromsignalausgangs ($I_{IST\_out}$) zu generieren und am Freigabeausgang ($I_{out\_ctrl}$) auszugeben.

5. Umformerschaltung nach einem der vorherigen Ansprüche,

- wobei die erste Grenzstromstärke 4 mA oder weniger, insb. mehr als 3,6 mA, beträgt; und/oder
- und wobei die zweite Grenzstromstärke 20 mA oder mehr, insb. weniger als 21 mA, beträgt.

6. Umformerschaltung nach einem der vorherigen Ansprüche, wobei die Umformerschaltung dafür eingerichtet ist - veranlaßt durch eine Störung des digitalen Meßsignals und/oder veranlaßt durch eine außerhalb des Meßbereichs liegenden Meßgröße - im Sonderbetriebsmodus betrieben zu werden.

7. Umformerschaltung nach dem vorherigen Anspruch, wobei die Umformerschaltung dafür eingerichtet ist, insb. automatisch und/oder gesteuert durch den Mikroprozessor, vom Normalbetriebsmodus in den Sonderbetriebsmodus zu wechseln.

8. Umformerschaltung nach einem der Ansprüche 5 bis 7,

- wobei die Umformerschaltung dafür eingerichtet ist, in einem Inbetriebnahmemodus betrieben zu werden, in dem der Mikroprozessor zunächst gestartet wird;
- und wobei der Mikroprozessor dafür eingerichtet ist, während des Inbetriebnahmemodus die Stromschnittstelle, insb. automatisch, zu überprüfen.

9. Umformerschaltung nach dem vorherigen Anspruch, wobei der Mikroprozessor dafür eingerichtet ist, während des Inbetriebnahmemodus die Stromschnittstelle, insb. automatisch, zu überprüfen, indem am Steuerausgang ein Life-Zero-Steuerwert, nämlich ein Steuerwert, der die Stromschnittstelle veranlaßt, die Stromstärke, $I_x$, des Signalstroms so zu regeln, daß der zugehörige stationäre Stromstärkepegel ($I_{x,j}$) einem einer kleinsten der beiden Grenzstromstärken, $I_1$, $I_2$, entsprechenden, insb. weniger als 4 mA und mehr als 3,6 mA betragenden, Life-Zero-Wert, nämlich einer einen stromführenden Nullpunkt der Umformerschaltung signalisierenden Stromstärke, entspricht, ausgegeben wird.

10. Umformerschaltung nach dem vorherigen Anspruch, wobei der Mikroprozessor dafür eingerichtet ist, während des Inbetriebnahmemodus die Stromschnittstelle automatisch zu überprüfen, indem, insb. zu einem späteren Zeitpunkt bzw. nachdem der Mikroprozessor wenigstens einen dem Life-Zero-Steuerwert entsprechenden digitalen Stromwert eingelesen hat, ein vom Life-Zero-Steuerwert abweichender Steuerwert, der die Stromschnittstelle veranlaßt, die Stromstärke, $I_x$, des Signalstroms so zu regeln, daß der zugehörige stationäre Stromstärkepegel ($I_{x,j}$) einem oberhalb der kleinsten der beiden Grenzstromstärken, $I_1$, $I_2$, liegenden Stromwert, insb. einem mehr als 20,5 mA und weniger als 23 mA betragenden Alarmstromwert, entspricht, ausgegeben wird.

11. Umformerschaltung nach einem der vorherigen Ansprüche, weiters umfassend: einen persistenten Datenspeicher (EEPROM), wobei der Mikroprozessor dafür eingerichtet ist, zumindest einen Steuerwert ($W_{D,j}$) und wenigstens einem zugehörigen digitalen Stromwert ($I_{D,j}$) und/oder eine Abweichung zwischen einem Steuerwert ($W_{D,j}$) und einem zugehörigen digitalen Stromwert ($I_{D,j}$) nicht-flüchtig im Datenspeicher (EEPROM) zu speichern, insb. zusammen mit einem Zeitwert, der mit einem Zeitpunkt des Speicherns korrespondiert.

**12.** Umformerschaltung nach einem der vorherigen Ansprüche,

- wobei der Mikroprozessor dafür eingerichtet ist, basierend auf der Steuerwertefolge ($w_D$) und der Stromwertefolge ($i_D$), insb. basierend auf gespeicherten Steuerwerten ($W_{D,j}$) sowie gespeicherten digitalen Stromwerten ($I_{D,j}$), einen Umformerfehler (Err) zu ermitteln; und/oder
- wobei die Umformerschaltung dafür eingerichtet ist, basierend auf der Steuerwertefolge und der Stromwertefolge zumindest gelegentlich zu überprüfen, ob ein stationärer Stromstärkepegel ($I_{x,j}$) mit dem dafür vorgegebenen Steuerwert ($W_{D,j}$) übereinstimmt bzw. inwieweit ein stationärer Stromstärkepegel ($I_{x,j}$) von dem dafür vorgegebenen Steuerwert ($W_{D,j}$) abweicht.

**13.** Umformerschaltung nach einem der vorherigen Ansprüche, wobei der Mikroprozessor dafür eingerichtet ist, die Steuerwerte ($W_{D,j}$) der Steuerwertefolge basierend auf einer von wenigstens zwei vorgegebenen, momentan gültigen Koeffizienten ($A_1,..., A_N$) bestimmten Rechenvorschrift, insb. gemäß einer Polynomfunktion

$$W_{D,j} = \sum_{k=1}^{N} A_k \cdot X_{D,j}^{k-1} = A_1 + A_2 \cdot X_{D,i} + ... + A_N \cdot X_{D,j}^{N-1}$$

, als Funktionswert einer, insb. linearen, Funktion wenigstens eines der digitalen Meßwerte ($X_{D,j}$) der Meßwertefolge zu ermitteln.

**14.** Umformerschaltung nach dem vorherigen Anspruch, wobei der Mikroprozessor dafür eingerichtet ist, gelegentlich
- nachdem eine Abweichung eines stationären Stromstärkepegels ($I_{x,j}$) von dem dafür vorgegebenen Steuerwert ($W_{D,j}$) bzw. eine Abweichung einer aktuellen Kennlinienfunktion, gemäß der die Stromschnittstelle die stationären Stromstärkepegel ($I_{x,j}$) in Abhängigkeit von den digitalen Steuerwerten ($W_{D,j}$) einstellt, von einer zuvor für die Stromschnittstelle ermittelten Kennlinienfunktion festgestellt ist - wenigstens einen Ersatz-Koeffizienten ($A'_M$) für wenigstens einen der momentan gültigen gleichwohl zu ersetzenden Koeffizienten ($A_M \in \{A_1,..., A_N\}$) zu ermitteln.

**15.** Meßgerät, umfassend:

- einen Meßaufnehmer (MA) zum Erfassen einer, insb. innerhalb eines vorgegebenen Meßbereichs, zeitlich veränderlichen physikalischen und/oder chemischen Meßgröße (x) und zum Generieren wenigstens eines einen zeitlichen Verlauf nämlicher Meßgröße (x) repräsentierenden analogen Meßsignals;
- einen mit dem Meßaufnehmer elektrisch gekoppelte, insb. in einem Elektronik-Gehäuse (H) untergebrachte, Meßgerät-Elektronik (ME), die dafür eingerichtet ist, das analoge Meßsignal in ein dieses, mithin einen zeitlichen Verlauf nämlicher Meßgröße (x) repräsentierendes digitales Meßsignal ($x_D$) zu wandeln, und die eine Umformerschaltung (Tr) gemäß einem der Ansprüche 1 bis 14 aufweist;
- sowie ein vom Mikroprozessor ($\mu$C) angesteuertes Anzeigeelement (HMI) zum Anzeigen von mittels des Mikroprozessors generierten Meßwerten und zum Anzeigen eines mittels eines Stromwerts und eines Steuerwerts gebildeten Wertepaares und/oder einer Abweichung eines Stromwerts von einem Steuerwert und/oder zum Anzeigen eines Umformerfehlers (Err).

**Claims**

**1.** Transducer circuit designed to convert a digital measured signal (xo) representing a chronological sequence of a physical and/or chemical measured variable (x) that changes over time, particularly within a predefined measuring range, to an analog measured value signal that depends on said digital measured signal, with a signal current ($i_x$) whose current strength represents a measured value (X) for the measured variable, wherein said transducer circuit comprises:

- a current interface (DCC)

-- with a control input ($I_{ctrl\_in}$),
-- with a current signal output ($I_{D\_out}$), and

-- with a current output ($I_1$, $I_2$); and

- a microprocessor ($\mu$C)

    -- with a measured signal input for the digital measured signal (xo),
    -- with a current signal input ($I_{D\_in}$) connected to the current signal output ($I_{D\_out}$) of the current interface and
    -- with a control output ($I_{ctrl\_out}$) connected to the control input ($I_{ctrl\_in}$) of the current interface;

- wherein the current interface is designed to

    -- allow the signal current to flow through the current output
    -- and, during this time,
    --- adjust both the strength of the signal current ($i_x$) to a stationary current strength level ($I_x$) corresponding to a control value ($W_{D,j}$) currently applied to the control input ($I_{ctrl\_in}$), in such a way that each of the stationary current strength levels is dependent on an associated control value according to a characteristic function, particularly linear, that is inherent to the current interface,
    --- and to output, at the current signal output ($I_{D\_out}$), a sequence of current values (io), specifically a sequence representing a chronological sequence of the strength of the signal current ($i_x$), said sequence being of digital current values ($I_{D,j}$) obtained for different times ($...,t_j,...,t_{j+n},...$) and currently representing the current strength; and

- wherein the microprocessor ($\mu$C) is designed to

    -- generate, on the basis of the digital measured signal (xo) at the measured signal input, a sequence of measured values, specifically a sequence representing a chronological sequence of the measured variable, said sequence being of digital measured values ($X_{D,i}$) obtained for different times ($t_i$) and currently representing the measured variable, and
    -- to generate, on the basis of the sequence of measured values, a sequence of control values ($w_D$), specifically a sequence of digital control values ($W_{D,j}$) for the current interface, and to output said sequence of control values at the control output, and

- wherein the microprocessor ($\mu$C) is designed to monitor and/or check the current interface on the basis of the sequence of control values ($w_D$) and the sequence of current values (io), particularly on the basis of control values ($W_{D,j}$) saved at least temporarily, as well as digital current values ($I_{D,j}$) saved at least temporarily, particularly to

    -- determine a deviation between a control value ($W_{D,j}$) and at least an associated digital current value ($I_{D,j}$)
    -- and/or determine to what extent a current value ($I_{D,j}$) deviates from an associated control value ($W_{D,j}$),
    -- and/or determine a current characteristic function, according to which the current interface regulates the stationary current strength levels ($I_{x,j}$) depending on the digital control values ($W_{D,j}$),
    -- and/or determine whether or to what extent a current characteristic function - according to which the current interface regulates the stationary current strength levels ($I_{x,j}$) depending on the digital control values ($W_{D,j}$) - deviates from an earlier characteristic function of the current interface;

- wherein the transducer circuit is designed to be operated temporarily, particularly primarily, in a normal operating mode

    -- in which the measured variable (x) only varies over time within a measuring range, $\Delta x_{12}$, predefined to this end, with a range lower limit, $x_1$, determined by a predefined minimum measured value for the measured variable (x), and a range upper limit $x_2$, determined by a predefined maximum measured value for the measured variable (x), and
    -- in which the microprocessor only outputs those control values at the control output that cause the current interface to regulate the current strength, $I_x$, of the signal current in such a way that the stationary current strength levels ($I_{x,j}$) are located respectively within a measuring span, $\Delta I_{12}$, predefined for this purpose, particularly corresponding to the measuring range, $\Delta x_{12}$, predefined for the measured variable (x), and therefore having a first limit current strength, $I_1$, corresponding to the range lower limit, $x_1$, and a second limit current strength, $I_2$, corresponding to the range upper limit, $x_2$, and being different to the first limit current strength;

- **characterized in that**

the transducer circuit is designed to be operated temporarily in a special operating mode - caused by an impermissibly high deviation of at least one of the stationary current strength levels ($I_{x,j}$) in relation to the control value ($W_{D,j}$) predefined for this purpose - in which the microprocessor outputs at the control output - particularly exclusively - those control values that cause the current interface to regulate the current strength, $I_x$, of the signal current in such a way that the stationary current strength levels ($I_{x,j}$) are located outside the predefined measuring span, $\Delta I_{12}$.

2. Transducer circuit as claimed in the previous claim, further comprising: a volatile data memory (RAM) for storing digital measured values and/or digital control values, wherein the microprocessor is designed to temporarily store digital control values ($W_{D,j}$) and digital current values ($I_{d,j}$) in the data memory.

3. Transducer circuit as claimed in one of the previous claims, wherein - on the basis of the sequence of control values ($w_D$) and the sequence of current values (io), particularly on the basis of control values ($W_{D,j}$) saved at least temporarily and digital current values ($I_{d,j}$) saved at least temporarily, the microprocessor is designed to check the current interface, specifically

   - to determine a deviation between a control value ($W_{D,j}$) and at least an associated digital current value ($I_{D,j}$); and/or
   - to determine to what extent said current value ($_{D,j}$) deviates from the control value ($W_{D,j}$); and/or
   - to determine a current characteristic function, according to which the current interface regulates the stationary current strength levels ($I_{x,j}$) depending on the digital control values (WD,j); and/or
   - to determine whether, and to what extent, a current characteristic function, according to which the current interface regulates the stationary current strength levels ($I_{x,j}$) depending on the digital control values ($W_{D,j}$), differs from a characteristic function determined beforehand for the current interface.

4. Transducer circuit as claimed in one of the previous claims,

   - wherein the current interface has an enable input (EN) and the microprocessor has an enable output ($I_{out\_ctrl}$) connected to the enable input of the current interface,
   - wherein the current interface is designed to output the sequence of current values (io) at the current signal output ($I_{IST\_out}$) after a control command (ON) activating the current signal output ($I_{IST\_out}$) is applied to the enable input (EN) and the microprocessor is designed to generate a control command to activate the current signal output ($I_{IST\_out}$) and to output it at the enable output ($I_{out\_ctrl}$).

5. Transducer circuit as claimed in one of the previous claims,

   - wherein the first limit current strength is 4 mA or less, particularly more than 3.6 mA; and/or
   - wherein the second limit current strength is 20 mA or more, particularly less than 21 mA.

6. Transducer circuit as claimed in one of the previous claims, wherein the transducer circuit is designed to be operated in the special operation mode - caused by a disturbance of the digital measured signal and/or caused by a measured variable that is outside the measuring range.

7. Transducer circuit as claimed in the previous claim, wherein the transducer circuit is designed to change from the normal operating mode to the special operation mode, particularly automatically and/or in a manner controlled by the microprocessor.

8. Transducer circuit as claimed in one of the Claims 5 to 7,

   - wherein the transducer circuit is designed to be operated in a commissioning mode in which the microprocessor is first started;
   - and wherein the microprocessor is designed to check the current interface, particularly automatically, during the commissioning mode.

9. Transducer circuit as claimed in the previous claim, wherein the microprocessor is designed to check the current interface, particularly automatically, during the commissioning mode, by outputting, at the control output, a Life-Zero control value, specifically a control value that causes the current interface to regulate the strength, $I_x$, of the signal

current in such a way that the associated stationary current strength level ($I_{x,j}$) corresponds to a current strength corresponding to smallest of the two limit current strengths, $I_1$, $I_2$, particularly to a Life-Zero value less than 4 mA and greater than 3.6 mA, specifically a current strength signaling a live zero point of the transducer circuit.

10. Transducer circuit as claimed in the previous claim, wherein the microprocessor is designed to automatically check the current interface during the commissioning mode, in that a control value that is different to the Life-Zero control value is output - particularly at a later time or after the microprocessor has read in at least one digital current value corresponding to the Life-Zero control value - wherein said Life-Zero control value causes the current interface to regulate the current strength, $I_x$, of the signal current in such a way that the associated stationary current strength level ($I_{x,j}$) corresponds to a current value located above the smallest of the two limit current strengths, $I_1$, $I_2$, particularly to an alarm current value that is greater than 20.5 mA and less than 23 mA.

11. Transducer circuit as claimed in one of the previous claims, further comprising: a persistent data memory (EEPROM), wherein the microprocessor is designed to save at least a control value ($W_{D,j}$) and at least an associated digital current value ($I_{D,j}$) and/or a deviation between a control value ($W_{D,j}$) and an associated digital current value ($I_{D,j}$) in a non-volatile manner in the data memory (EEPROM), particularly together with a time value corresponding to a data storage time.

12. Transducer circuit as claimed in one of the previous claims,

- wherein the microprocessor is designed to determine a conversion error (Err) on the basis of the sequence of control values ($w_D$) and the sequence of current values (io), particularly on the basis of saved control values ($W_{D,j}$) and saved digital current values ($I_{D,j}$); and/or
- wherein the transducer circuit is designed to at least occasionally check, on the basis of the sequence of control values and the sequence of current values, whether a stationary current strength level ($I_{x,j}$) corresponds to the control value ($W_{D,j}$) predefined for this purpose or to what extent a stationary current strength level ($I_{x,j}$) deviates from the control value ($W_{D,j}$) predefined for this purpose.

13. Transducer circuit as claimed in one of the previous claims, wherein the microprocessor is designed to determine the control values ($W_{D,j}$) of the control value sequence on the basis of a calculation rule specified by at least two predefined coefficients ($A_1$, ..., $A_N$) which are currently valid, particularly according to a polynomial function

$$W_{D,j} = \sum_{k=1}^{N} A_k \cdot X_{D,j}^{k-1} = A_1 + A_2 \cdot X_{D,j} + \ldots + A_N \cdot X_{D,j}^{N-1}$$

, as a function value of a function, particularly linear, of at least one of the digital measured values ($X_{D,j}$) of the measured value sequence.

14. Transducer circuit as claimed in the previous claim, wherein the microprocessor is designed to occasionally determine at least a replacement coefficient (A'M) for at least one of the coefficients ($A_M \in \{AI, ..., A_N\}$) that is currently valid but should be replaced following a deviation of a stationary current strength level ($I_{x,j}$) from the control value ($W_{D,j}$) predefined for this purpose, or following a deviation of a current characteristic function - according to which the current interface regulates the stationary current strength levels ($I_{x,j}$) depending on the digital control values ($W_{D,j}$) - from a characteristic function determined beforehand for the current interface.

15. Measuring device, comprising:

- a sensor (MA) designed to measure a physical and/or chemical measured variable (x), which varies over times, particularly within a predefined measuring range, and to generate at least an analog measured signal representing a chronological sequence of said measured variable (x);
- a measuring device electronics unit (ME), which is electrically coupled to the sensor and is particularly accommodated in an electronic housing (H) and is designed to convert the analog measured signal to a digital measured signal (xo) representing this signal, and therefore representing a chronological sequence of said measured variable (x), and wherein said unit has a transducer circuit (Tr) as claimed in one of the Claims 1 to 14;
- as well as a display element (HMI) controlled by the microprocessor ($\mu$C), wherein said element is designed to display measured values generated by the microprocessor, and to display a value pair formed by a current value and a control value and/or a deviation of a current value from a control value, and/or to display a conversion error (Err).

**Revendications**

1. Circuit convertisseur destiné à convertir un signal de mesure numérique ($x_D$) représentant une évolution dans le temps d'une grandeur de mesure physique et/ou chimique (x) variable dans le temps, notamment à l'intérieur d'une gamme de mesure prédéfinie, en un signal de valeur mesurée analogique dépendant du signal de mesure numérique, avec un courant de signal ($i_x$) dont une intensité de courant représente une valeur mesurée (X) pour la grandeur de mesure, lequel circuit convertisseur comprend :

   - une interface de courant (DCC)

      -- avec une entrée de commande ($I_{ctr\_in}$),
      -- avec une sortie de signal de courant ($I_{D\_out}$), et
      -- avec une sortie de courant ($I_1$, $I_2$) ; ainsi que

   - un microprocesseur ($\mu C$)

      -- avec une entrée de signal de mesure pour le signal de mesure numérique ($x_D$),
      -- avec une entrée de signal de courant ($I_{D\_in}$) reliée à la sortie de signal de courant ($I_{D\_out}$) de l'interface de courant et
      -- avec une sortie de commande ($I_{ctrl\_out}$) reliée à l'entrée de commande ($I_{ctrl\_in}$) de l'interface de courant ;

   - l'interface de courant étant conçue pour

      -- laisser passer le courant de signal à travers la sortie de courant
      -- et, pendant ce temps,
      --- pour régler à la fois l'intensité du courant de signal ($i_x$) à un niveau d'intensité de courant stationnaire ($I_x$) correspondant à une valeur de commande ($W_{D,j}$) appliquée momentanément à l'entrée de commande ($I_{ctrl\_in}$), de telle sorte que chacun des niveaux d'intensité de courant stationnaires est dépendant, selon une fonction caractéristique, notamment linéaire, immanente à l'interface de courant, de chaque valeur de commande correspondante,
      --- ainsi que de délivrer à la sortie du signal de courant ($I_{D\_out}$) une séquence de valeurs de courant ($i_D$), à savoir une séquence représentant une évolution dans le temps de l'intensité du courant de signal ($i_x$), de valeurs de courant numériques ($I_{D,j}$) obtenues pour différents instants (...,$t_j$,...,$t_{j+n}$,...) et représentant momentanément l'intensité du courant ; et

   - le microprocesseur ($\mu C$) étant conçu pour générer,

      -- sur la base du signal de mesure numérique ($x_D$) à l'entrée du signal de mesure, une séquence de valeurs mesurées, à savoir une séquence représentant une évolution temporelle de la grandeur de mesure, de valeurs mesurées numériques ($X_{D,i}$) obtenues pour différents instants ($t_i$) et représentant momentanément la grandeur de mesure, et
      -- sur la base de la séquence de valeurs mesurées, pour générer une séquence de valeurs de commande ($w_D$), à savoir une séquence de valeurs de commande numériques ($W_{D,j}$) pour l'interface de courant, et pour délivrer ladite séquence de valeurs de commande à la sortie de commande, et

   - le microprocesseur ($\mu C$) étant conçu pour surveiller et/ou vérifier l'interface de courant sur la base de la séquence de valeurs de commande ($w_D$) et de la séquence de valeurs de courant ($i_D$), notamment sur la base de valeurs de commande ($W_{D,j}$) mémorisées au moins temporairement, ainsi que de valeurs de courant numériques ($I_{D,j}$) mémorisées au moins temporairement, notamment pour

      -- déterminer un écart entre une valeur de commande ($W_{D,j}$) et au moins une valeur de courant numérique ($I_{D,j}$) correspondante
      -- et/ou constater dans quelle mesure une valeur de courant ($I_{D,j}$) s'écarte d'une valeur de commande ($W_{D,j}$) correspondante,
      -- et/ou déterminer une fonction caractéristique actuelle, selon laquelle l'interface de courant règle les niveaux d'intensité de courant stationnaires ($I_{x,j}$) en fonction des valeurs de commande numériques ($W_{D,j}$),
      -- et/ou constater si ou dans quelle mesure une fonction caractéristique actuelle - selon laquelle l'interface de courant règle les niveaux d'intensité de courant stationnaires ($I_{x,j}$) en fonction des valeurs de commande numériques ($W_{D,j}$) - s'écarte d'une fonction caractéristique antérieure de l'interface de courant ;

- le circuit convertisseur étant conçu pour être exploité temporairement, notamment principalement, dans un mode de fonctionnement normal

-- dans lequel la grandeur mesurée (x) varie dans le temps uniquement à l'intérieur d'une gamme de mesure, $\Delta x_{12}$, prédéfinie à cet effet, avec une limite inférieure de gamme, $x_1$, déterminée par une valeur mesurée minimale prédéfinie pour la grandeur mesurée (x), et une limite supérieure de gamme, déterminée par une valeur mesurée maximale prédéfinie pour la grandeur mesurée (x), et

-- dans lequel le microprocesseur ne délivre à la sortie de commande que des valeurs de commande qui amènent l'interface de courant à régler l'intensité de courant, $I_x$, du courant de signal de telle sorte que les niveaux d'intensité de courant stationnaires ($I_{x,j}$) se situent respectivement à l'intérieur d'une étendue de mesure, $\Delta I_{12}$, prédéfinie à cet effet, notamment correspondant avec la gamme de mesure, $\Delta x_{12}$, prédéfinie pour la grandeur mesurée (x), et donc présentant une première intensité limite, $I_1$, correspondant à la limite inférieure de gamme, $x_1$, ainsi qu'une deuxième intensité limite, $I_2$, correspondant à la limite supérieure de gamme, $x_2$, et différente de la première intensité limite ;

- **caractérisé en ce que**

le circuit convertisseur est conçu pour être exploité - en raison d'un écart élevé inadmissible d'au moins l'un des niveaux d'intensité de courant stationnaires ($I_{x,j}$) par rapport à la valeur de commande ($W_{D,j}$) prédéfinie à cet effet - temporairement dans un mode de fonctionnement spécial, dans lequel le microprocesseur délivre à la sortie de commande, notamment exclusivement, des valeurs de commande qui amènent l'interface de courant à régler l'intensité de courant, $I_x$, du courant de signal de telle sorte que les niveaux d'intensité de courant stationnaires ($I_{x,j}$) se situent en dehors de l'étendue de mesure, $\Delta I_{12}$, prédéfinie.

2. Circuit convertisseur selon la revendication précédente, comprenant en outre : une mémoire de données volatile (RAM) destinée à mémoriser des valeurs mesurées numériques et/ou des valeurs de commande numériques, le microprocesseur étant conçu pour mémoriser temporairement des valeurs de commande numériques ($W_{D,j}$) ainsi que des valeurs de courant numériques ($I_{d,j}$) dans la mémoire de données.

3. Circuit convertisseur selon l'une des revendications précédentes, pour lequel le microprocesseur est conçu pour - sur la base de la séquence de valeurs de commande ($w_D$) et de la séquence de valeurs de courant ($i_D$), notamment sur la base de valeurs de commande ($W_{D,j}$) mémorisées au moins temporairement, ainsi que de valeurs de courant numériques ($I_{D,j}$) mémorisées au moins temporairement - contrôler l'interface de courant, à savoir

- déterminer un écart entre une valeur de commande ($W_{D,j}$) et au moins une valeur de courant numérique ($I_{D,j}$) correspondante ; et/ou
- déterminer dans quelle mesure ladite valeur de courant ($_{D,j}$) s'écarte de la valeur de commande ($W_{D,j}$) ; et/ou
- déterminer une fonction caractéristique actuelle, selon laquelle l'interface de courant règle les niveaux d'intensité de courant stationnaires ($I_{x,j}$) en fonction des valeurs de commande numériques (WD,j) ; et/ou
- déterminer si, et dans quelle mesure, une fonction caractéristique actuelle, selon laquelle l'interface de courant règle les niveaux d'intensité de courant stationnaires ($I_{x,j}$) en fonction des valeurs de commande numériques ($W_{D,j}$), diffère d'une fonction caractéristique déterminée auparavant pour l'interface de courant.

4. Circuit convertisseur selon l'une des revendications précédentes,

- pour lequel l'interface de courant présente une entrée de validation (EN) et le microprocesseur présente une sortie de validation ($I_{out\_ctrl}$) reliée à l'entrée de validation de l'interface de courant,
- pour lequel l'interface de courant est conçue pour délivrer la séquence de valeurs de courant ($i_D$) à la sortie de signal de courant ($I_{IST\_out}$), après qu'une instruction de commande (ON) activant la sortie de signal de courant ($I_{IST\_out}$) a été appliquée à l'entrée de validation (EN) et que le microprocesseur est conçu pour générer une instruction de commande pour activer la sortie de signal de courant ($I_{IST\_out}$) et la délivrer à la sortie de validation ($I_{out\_ctrl}$).

5. Circuit convertisseur selon l'une des revendications précédentes,

- pour lequel la première intensité de courant limite est de 4 mA ou moins, notamment de plus de 3,6 mA ; et/ou

- et la deuxième intensité de courant limite est de 20 mA ou plus, notamment de moins de 21 mA.

**6.** Circuit convertisseur selon l'une des revendications précédentes, pour lequel le circuit convertisseur est conçu pour être exploité en mode de fonctionnement spécial - provoqué par une perturbation du signal de mesure numérique et/ou provoqué par une grandeur de mesure située en dehors de la gamme de mesure.

**7.** Circuit convertisseur selon l'une des revendications précédentes, pour lequel le circuit convertisseur est conçu pour passer du mode de fonctionnement normal au mode de fonctionnement spécial, notamment automatiquement et/ou de manière contrôlée par le microprocesseur.

**8.** Circuit convertisseur selon l'une des revendications 5 à 7,

- pour lequel le circuit convertisseur est conçu pour fonctionner dans un mode de mise en service dans lequel le microprocesseur est dans un premier temps démarré ;
- et pour lequel le microprocesseur est conçu pour vérifier l'interface de courant, notamment automatiquement, pendant le mode de mise en service.

**9.** Circuit convertisseur selon la revendication précédente, pour lequel le microprocesseur est conçu pour contrôler l'interface de courant, notamment automatiquement, pendant le mode de mise en service, en ce qu'une valeur de commande Life-Zero, à savoir une valeur de commande qui amène l'interface de courant à régler l'intensité, $I_x$, du courant de signal de telle sorte que le niveau d'intensité de courant stationnaire ($I_{x,j}$) associé corresponde à une intensité de courant correspondant à la plus petite des deux intensités de courant limites, $I_1$, $I_2$, notamment à une valeur Life-Zero inférieure à 4 mA et supérieure à 3,6 mA, à savoir une intensité de courant signalant un point zéro de conduction de courant du circuit convertisseur.

**10.** Circuit convertisseur selon la revendication précédente, pour lequel le microprocesseur est conçu pour vérifier automatiquement l'interface de courant pendant le mode de mise en service, en ce que, notamment à un instant ultérieur ou après que le microprocesseur ait lu au moins une valeur de courant numérique correspondant à la valeur de commande Life-Zero, une valeur de commande différente de la valeur de commande Life-Zero - qui amène l'interface de courant à régler l'intensité de courant, $I_x$, du courant de signal de telle sorte que le niveau d'intensité de courant stationnaire correspondant ($I_{x,j}$) correspond à une valeur de courant située au-dessus de la plus petite des deux intensités de courant limites, $I_1$, $I_2$, notamment à une valeur de courant d'alarme supérieure à 20,5 mA et inférieure à 23 mA - est émise.

**11.** Circuit convertisseur selon l'une des revendications précédentes, comprenant en outre : une mémoire de données persistante (EEPROM), le microprocesseur étant conçu pour mémoriser de manière non volatile dans la mémoire de données (EEPROM) au moins une valeur de commande ($W_{D,j}$) et au moins une valeur de courant numérique ($I_{D,j}$) associée et/ou un écart entre une valeur de commande ($W_{D,j}$) et une valeur de courant numérique ($I_{D,j}$) associée, notamment conjointement avec une valeur de temps correspondant à un instant de mémorisation.

**12.** Circuit convertisseur selon l'une des revendications précédentes,

- pour lequel le microprocesseur est conçu pour déterminer, sur la base de la séquence de valeurs de commande ($w_D$) et de la séquence de valeurs de courant ($i_D$), notamment sur la base de valeurs de commande mémorisées ($W_{D,j}$) ainsi que de valeurs de courant numériques mémorisées ($I_{D,j}$), une erreur de conversion (Err) ; et/ou
- pour lequel le circuit convertisseur est conçu pour vérifier au moins occasionnellement, sur la base de la séquence de valeurs de commande et de la séquence de valeurs de courant, si un niveau d'intensité de courant stationnaire ($I_{x,j}$) correspond à la valeur de commande ($W_{D,j}$) prédéfinie à cet effet ou dans quelle mesure un niveau d'intensité de courant stationnaire ($I_{x,j}$) s'écarte de la valeur de commande ($W_{D,j}$) prédéfinie à cet effet.

**13.** Circuit convertisseur selon l'une des revendications précédentes, pour lequel le microprocesseur est conçu pour déterminer les valeurs de commande ($W_{D,j}$) de la séquence de valeurs de commande sur la base d'une règle de calcul déterminée par au moins deux coefficients ($A_1$, ..., $A_N$) prédéfinis et momentanément valables, notamment selon une fonction polynomiale $$W_{D,j} = \sum_{k=1}^{N} A_k \cdot X_{D,j}^{k-1} = A_1 + A_2 \cdot X_{D,j} + ... + A_N \cdot X_{D,j}^{N-1}$$ , en tant que valeur d'une fonction, notamment linéaire, d'au moins l'une des valeurs mesurées numériques ($X_{D,j}$) de la séquence de valeurs mesurées.

**14.** Circuit convertisseur selon la revendication précédente, pour lequel le microprocesseur est conçu pour déterminer occasionnellement - après qu'un écart d'un niveau d'intensité de courant stationnaire ($I_{x,j}$) par rapport à la valeur de commande ($W_{D,j}$) prédéfinie à cet effet, ou un écart d'une fonction caractéristique actuelle, selon lequel l'interface de courant règle les niveaux d'intensité de courant stationnaires ($I_{x,j}$) en fonction des valeurs de commande numériques ($W_{D,j}$), par rapport à une fonction caractéristique déterminée auparavant pour l'interface de courant - au moins un coefficient de remplacement (A'M) pour au moins l'un des coefficients ($A_M \in \{Al, ..., A_N\}$) valables actuellement mais devant être remplacés.

**15.** Appareil de mesure, comprenant :

- un capteur (MA) destiné à mesurer une grandeur de mesure physique et/ou chimique (x) variable dans le temps, notamment à l'intérieur d'une gamme de mesure prédéfinie, et à générer au moins un signal de mesure analogique représentant une évolution dans le temps de la même grandeur de mesure (x) ;
- une électronique d'appareil de mesure (ME), laquelle est couplée électriquement au capteur et est notamment logée dans un boîtier électronique (H), laquelle électronique est conçue pour convertir le signal de mesure analogique en un signal de mesure numérique ($x_D$) représentant celui-ci, c'est-à-dire une évolution dans le temps de la même grandeur de mesure (x), et laquelle électronique présente un circuit convertisseur (Tr) selon l'une des revendications 1 à 14 ;
- ainsi qu'un élément d'affichage (HMI) commandé par le microprocesseur ($\mu$C), lequel élément d'affichage est destiné à afficher des valeurs mesurées générées au moyen du microprocesseur, et à afficher une paire de valeurs formée au moyen d'une valeur de courant et d'une valeur de commande et/ou un écart entre une valeur de courant et une valeur de commande, et/ou à afficher une erreur de conversion (Err).

**Fig. 1**

*Fig. 2*

Fig. 3

**Fig. 4**

EP 2 936 686 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1591977 A
- GB 2229897 A
- US 20010016802 A
- US 20100026322 A
- US 20110062942 A
- US 5672975 A
- US 6014100 A
- US 6140940 A
- US 6452493 B
- US 6472884 B
- US 6684340 B
- US 7162651 B
- US 7296482 B
- US 7630844 B
- US 7778784 B
- US 7792646 B

- WO 0026739 A
- WO 0048157 A
- WO 0171291 A
- WO 03106931 A
- WO 2008091548 A
- WO 2009002341 A
- WO 2011005938 A
- WO 2012009003 A
- WO 2012159683 A
- WO 8802476 A
- WO 8802853 A
- WO 9420940 A
- WO 9508123 A
- WO 9508758 A
- EP 2012057791 W

**In der Beschreibung aufgeführte Nicht-Patentliteratur**

- Complete Closed-Loop Precision Analog Microcontroller Thermocouple Measurement System with 4 mA to 20 mA Output. *Analog Devices Circuit Note CN-0300,* Oktober 2012, 1-6